# EUROPEAN PATENT SPECIFICATION

(11) **EP 4 586 319 B1**
(45) Date of publication and mention of the grant of the patent: **02.12.2026**
(21) Application number: 23929079.4
(22) Date of filing: 24.03.2023
(51) Int. Cl.: H10D 86/40, G09G 3/3266, H10K 59/131, H10D 86/00

(54) **DISPLAY SUBSTRATE AND DISPLAY DEVICE**
ANZEIGESUBSTRAT UND ANZEIGEVORRICHTUNG
SUBSTRAT D'AFFICHAGE ET DISPOSITIF D'AFFICHAGE

(43) Date of publication of application: 16.07.2025
(60) Divisional application: 26212876.2
(73) Proprietor: Boe Technology Group Co., Ltd., Beijing 100015 (CN); Chengdu BOE Optoelectronics Technology Co., Ltd., Chengdu, Sichuan 611731 (CN)
(72) Inventor: GU, Quanyong, Beijing 100176 (CN); YU, Ziyang, Beijing 100176 (CN); SONG, Gukhwan, Beijing 100176 (CN); GUO, Yonglin, Beijing 100176 (CN); JIANG, Zhiliang, Beijing 100176 (CN); ZHANG, Tiaomei, Beijing 100176 (CN); NIU, Ge, Beijing 100176 (CN); CHEN, Wenbo, Beijing 100176 (CN); WANG, Mengqi, Beijing 100176 (CN); ZHAO, Pan, Beijing 100176 (CN); LI, Yujing, Beijing 100176 (CN); WANG, Shilong, Beijing 100176 (CN); ZHAO, Erjin, Beijing 100176 (CN); HU, Ming, Beijing 100176 (CN)
(74) Representative: Durán-Corretjer, S.L.P.
(86) International application number: PCT/CN2023/083824
(87) International publication number: WO 2024/197476

(56) References cited:
- CN-A- 107 945 728
- CN-A- 114 664 911
- CN-A- 115 472 656
- CN-A- 115 707 308
- JP-A- 2009 080 386
- KR-A- 20160 002 337
- US-A1- 2014 332 769
- US-A1- 2019 005 885
- US-A1- 2019 131 295
- US-A1- 2022 068 212

## Description

### Technical Field

The present disclosure relates to, but is not limited to, the field of display technologies, in particular to a display substrate and a display apparatus.

### Background

With the development of display technology, the market has increasingly requirements for screens of display products, which not only requires display effect of display products, but also requires the display products to ensure normal display effect under more harsh conditions, such as high temperature, low temperature, or high static electricity environment.

The prior art (US2019/005885A1) provides a display device, which includes a substrate including an active area having a plurality of pixels and a bezel area around the active area; a data driver on one side of the bezel area; a gate driver on at least one side of the bezel area; a shield power supply line extending from the data driver to at least one side of the gate driver; and a shield layer overlapped with at least one thin film transistor of the gate driver and connected to the shield power supply line in the bezel area.

The prior art (US2019/131295A1) provides an array substrate assembly, a method of manufacturing the array substrate assembly, a display panel and a display apparatus. The array substrate assembly includes a drive control circuit located on the substrate and configured for driving. The drive control circuit includes a plurality of thin film transistors each including an active layer. The array substrate further includes a grounded electrostatic shield layer. The electrostatic shield layer is located between the substrate and the drive control circuit, and an orthogonal projection of the electrostatic shield layer on the substrate covers orthogonal projections of at least the active layers of the plurality of thin film transistors of the drive control circuit on the substrate.

### Summary

The present invention provides a display substrate and a display apparatus according to the appended independent claims. Further improvements and embodiments are provided in the appended dependent claims. Embodiments of the invention are those whose scope is within that of the appended claims. Other passages stating embodiments which do not fall under the scope of the appended claims are to be considered as examples for illustration.

### Brief Description of Drawings

Accompanying drawings are used for providing further understanding of technical solutions of the present disclosure, constitute a part of the specification, and are used for explaining the technical solutions of the present disclosure together with embodiments of the present disclosure, but do not constitute limitations on the technical solutions of the present disclosure. Shapes and sizes of one or more components in the drawings do not reflect actual scales, and are only intended to schematically describe contents of the present disclosure.
FIG. 1 is a schematic plan view of a display substrate.
FIG. 2 is a schematic diagram showing the operation of a base substrate under an electrostatic field.
FIG. 3 is an equivalent circuit diagram of a scan drive sub-circuit according to at least one embodiment of the present disclosure.
FIG. 4 is an operating timing diagram of a scan drive sub-circuit of the scan drive circuit shown in FIG. 3.
FIG. 5 is a schematic partial plan view of a peripheral region according to at least one embodiment of the present disclosure.
FIG. 6A is a schematic partial plan view of a peripheral region after a bottom metal layer is formed in FIG. 5.
FIG. 6B is a schematic partial plan view of a peripheral region after a semiconductor layer is formed in FIG. 5.
FIG. 6C is a schematic partial plan view of a peripheral region after a first conductive layer is formed in FIG. 5.
FIG. 6D is a schematic partial plan view of a peripheral region after a second conductive layer is formed in FIG. 5.
FIG. 6E is a schematic partial plan view of a peripheral region after a fourth insulation layer is formed in FIG. 5.
FIG. 6F is a schematic partial plan view of a peripheral region after a third conductive layer is formed in FIG. 5.
FIG. 7 is a schematic partial view of a display region and a peripheral region according to at least one embodiment of the present disclosure.
FIG. 8 is an equivalent circuit diagram of a pixel circuit of a display region according to at least one embodiment of the present disclosure.
FIG. 9 is an operating timing diagram of the pixel circuit shown in FIG. 8.
FIG. 10 is a schematic partial plan view of a display region according to at least one embodiment of the present disclosure.
FIG. 11 is another schematic partial plan view of a peripheral region according to at least one embodiment of the present disclosure.
FIG. 12A is a schematic partial plan view of a peripheral region after a bottom metal layer is formed in FIG. 11.
FIG. 12B is a schematic partial plan view of a peripheral region after a first conductive layer is formed in FIG. 11.
FIG. 12C is a schematic partial plan view of a bottom metal layer according to at least one embodiment of the present disclosure.
FIG. 12D is another schematic partial plan view of a bottom metal layer according to at least one embodiment of the present disclosure.
FIG. 13 is another schematic partial plan view of a peripheral region no in accordance with the claimed invention
FIG. 14A is a schematic partial plan view of a peripheral region after a bottom metal layer is formed in FIG. 13.
FIG. 14B is a schematic partial plan view of a peripheral region after a first conductive layer is formed in FIG. 13.
FIG. 15 is another schematic partial plan view of a peripheral region not in accordance with the claimed invention.
FIG. 16A is a schematic partial plan view of a peripheral region after a bottom metal layer is formed in FIG. 15.
FIG. 16B is a schematic partial plan view of a peripheral region after a first conductive layer is formed in FIG. 15.
FIG. 17 is another schematic partial plan view of a peripheral region not in accordance with the claimed invention.
FIG. 18 is another schematic partial plan view of a peripheral region not in accordance with the claimed invention.
FIG. 19 is an equivalent circuit diagram of a light emitting drive sub-circuit not in accordance with the claimed invention.
FIG. 20 is an operating timing diagram of the light emitting drive sub-circuit shown in FIG. 19.
FIG. 21 is a schematic partial plan view of a peripheral region not in accordance with the claimed invention.
FIG. 22A is a schematic partial plan view of a peripheral region after a bottom metal layer is formed in FIG. 21.
FIG. 22B is a schematic partial plan view of a peripheral region after a first conductive layer is formed in FIG. 21.
FIG. 23 is a schematic partial plan view of a peripheral region according to at least one embodiment of the present disclosure.
FIG. 24A is a schematic partial plan view of a peripheral region after a bottom metal layer is formed in FIG. 23.
FIG. 24B is a schematic partial plan view of a peripheral region after a first conductive layer is formed in FIG. 23.
FIG. 25 is a schematic partial plan view of a peripheral region not in accordance with the claimed invention.
FIG. 26 is a schematic partial plan view of a peripheral region after a bottom metal layer is formed in FIG. 25.
FIG. 27 is a schematic partial plan view of a peripheral region not in accordance with the claimed invention.
FIG. 28 is a schematic partial plan view of a peripheral region after a bottom metal layer is formed in FIG. 27.
FIG. 29 is a schematic partial view of a bottom metal layer of a peripheral region not in accordance with the claimed invention.
FIG. 30 is a schematic partial plan view of a peripheral region according to at least one embodiment of the present disclosure.
FIG. 31A is a schematic partial plan view of a peripheral region after a bottom metal layer is formed in FIG. 30.
FIG. 31B is a schematic partial plan view of a peripheral region after a semiconductor layer is formed in FIG. 30.
FIG. 31C is a schematic partial plan view of a peripheral region after a first conductive layer is formed in FIG. 30.
FIG. 32 is a schematic diagram of a display apparatus according to at least one embodiment of the present disclosure.

### Detailed Description

The embodiments of the present disclosure will be described below with reference to the drawings in detail. Implementation modes may be implemented in multiple different forms. Those of ordinary skills in the art may easily understand such a fact that implementations and contents may be transformed into other forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

In the drawings, a size of one or more constituent elements, a thickness of a layer, or a region is sometimes exaggerated for clarity. Therefore, one implementation of the present disclosure is not necessarily limited to the size, and a shape and a size of one or more components in the drawings do not reflect an actual scale. In addition, the accompanying drawings schematically illustrate ideal examples, and an implementation of the present disclosure is not limited to shapes, numerical values, or the like shown in the drawings.

Ordinal numerals "first", "second", "third", etc., in the specification are set not to form limits in numbers but only to avoid confusion between composition elements. In the present disclosure, "plurality" represents two or more than two.

In the specification, for convenience, expressions "central", "above", "below", "front", "back", "vertical", "horizontal", "top", "bottom", "inside", "outside", etc., indicating directional or positional relationships are used to illustrate positional relationships between the composition elements, not to indicate or imply that involved apparatuses or elements are required to have specific orientations and be structured and operated with the specific orientations but only to easily and simply describe the present specification, and thus should not be understood as limitations on the present disclosure. The positional relationships between the constituent elements are changed as appropriate according to a direction where the constituent elements are described. Therefore, appropriate replacements based on situations are allowed, which is not limited to the expressions in the specification.

In the specification, unless otherwise specified and defined, terms "mounting", "mutual connection", and "connection" should be understood in a broad sense. For example, it may be a fixed connection, a detachable connection, or an integral connection; it may be a mechanical connection or a connection; it may be a direct connection, an indirect connection through a middleware, or an internal communication inside two elements. Those of ordinary skills in the art may understand meanings of the aforementioned terms in the present disclosure according to situations.

In the specification, "electrical connection" includes connection of composition elements through an element with a certain electrical action. The "element with a certain electrical action" is not particularly limited as long as electrical signals between the connected constituent elements may be transmitted. Examples of the "element with a certain electrical action" not only include an electrode and a wiring, but also include a switching element such as a transistor, a resistor, an inductor, a capacitor, another element with multiple functions, etc.

In the specification, a transistor refers to an element which at least includes three terminals, i.e., a gate, a drain, and a source. The transistor has a channel region between the drain (drain electrode terminal, drain region, or drain electrode) and the source (source electrode terminal, source region, or source electrode), and a current can flow through the drain, the channel region, and the source. In the specification, the channel region refers to a region through which a current mainly flows.

In the specification, a first electrode may be a drain and a second electrode may be a source, or, a first electrode may be a source and a second electrode may be a drain. In a case that transistors with opposite polarities are used, or in a case that a direction of a current is changed during operation of a circuit, or the like, functions of the "source" and the "drain" are sometimes interchangeable. Therefore, the "source" and the "drain" are interchangeable in the specification. In addition, the gate may also be referred to as a control electrode.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In this specification, a circle, oval, triangle, rectangle, trapezoid, pentagon or hexagon, etc. is not strictly speaking, but may be an approximate circle, oval, triangle, rectangle, trapezoid, pentagon or hexagon, etc. Some small deformations due to tolerances may exist, for example, guide angles, curved edges and deformations thereof may exist.

In the present disclosure, "about" and "substantially" refer to that a boundary is not defined strictly and a case within a range of process and measurement errors is allowed. In the present disclosure, "substantially the same" refers to a case where numerical values differ by less than 10%.

In the present disclosure, "A extends along a B direction" means that A may include a main body portion and a secondary portion connected with the main body portion, the main body portion is a line, a line segment, or a strip-shaped body, the main body portion extends along the B direction, and a length of the main body portion extending along the B direction is greater than a length of the secondary portion extending along another direction. "A extends in in the B direction" in the present disclosure means "the main portion of A extends in the B direction".

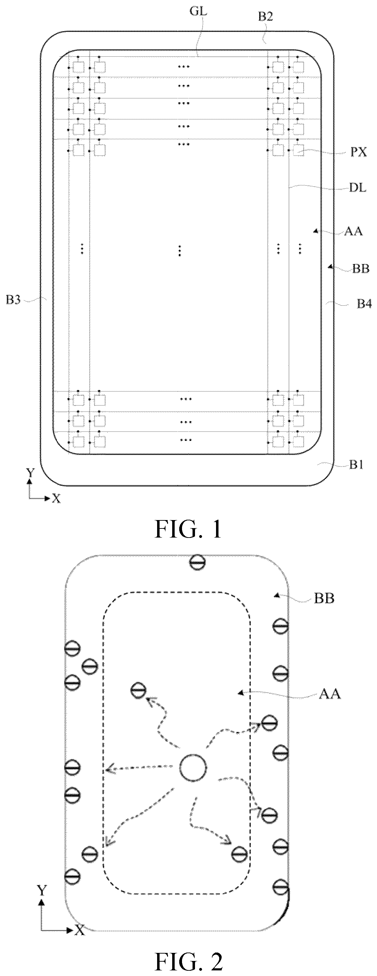

FIG. 1 is a schematic plan view of a display substrate. In some examples, as shown in FIG. 1, the display substrate of the present embodiment may include a display region AA, and a peripheral region BB surrounding a periphery of the display region AA. The peripheral region BB may include a first bezel region located on one side of the display region AA, and a second bezel region located on other sides of the display region AA. The second bezel region may be located at least on two sides of the first bezel region. For example, the first bezel region may include a lower bezel B1 of the display substrate, and the second bezel region may include an upper bezel B2, a left bezel B3, and a right bezel B4 of the display substrate. The upper bezel B2 is opposite to the lower bezel B1, and the left bezel B3 is opposite to the right bezel B4.

In some examples, the display region AA may be a flat region including a plurality of sub-pixels PX that form a pixel array, wherein the plurality of sub-pixels PX may be configured to display a dynamic picture or a static image. The display region AA may be referred to as an effective region. In some examples, the display substrate may be a flexible substrate. Accordingly, the display substrate may be deformable, for example, crimped, bent, folded, or curled.

In some examples, the second bezel region may include a circuit region, a power supply line region, a crack dam region, and a cutting region which are sequentially disposed along a direction of the display region AA. The circuit region may be connected to the display region AA, and the circuit region may include a gate drive circuit. For example, the gate drive circuit may include a plurality of cascaded shift registers, and the plurality of shift registers may be electrically connected with a plurality of gate lines in the display region AA. The power supply line region is connected to the circuit region and may at least include peripheral power supply traces (e.g. a low-level power supply line), and the low-level power supply line extends along a direction parallel to an edge of the display region and is connected with a cathode in the display region AA. The crack dam region may be connected to the power supply line region, and may at least include multiple cracks disposed on the composite insulation layer. The cutting region may be connected to the crack dam region, and may at least include a cutting groove disposed on the composite insulation layer. The cutting grooves are configured such that a cutting device cuts along the cutting grooves respectively after preparation of all film layers of the display substrate are completed.

In some examples, the first bezel region and the second bezel region may be provided with a first isolation dam and a second isolation dam, which may extend in a direction parallel to an edge of the display region to form a ring structure surrounding the display region AA, and the edge of the display region may be an edge of the display region close to the first bezel region or the second bezel region.

In some examples, as shown in FIG. 1, the display region AA may at least include a plurality of sub-pixels PX, a plurality of gate lines GL, and a plurality of data lines DL. The plurality of gate lines GL may extend in a first direction X and be arranged in a second direction Y; and the plurality of data lines DL may extend in the second direction Y and be arranged in the first direction X. Orthographic projections of the plurality of gate lines G on the base substrate and orthographic projections of the plurality of data lines D on the base substrate intersect to form a plurality of sub-pixel regions, and one sub-pixel PX is disposed in each sub-pixel region. The plurality of data lines DL are electrically connected with the plurality of sub-pixels PX, and the plurality of data lines DL may be configured to provide data signals to the plurality of sub-pixels PX. The plurality of data lines DL may extend to a bonding region B1. The plurality of gate lines GL are electrically connected with the plurality of sub-pixels PX, and the plurality of gate lines GL may be configured to provide gate control signals to the plurality of sub-pixels PX. In some examples, the gate control signals may include a scan signal or may include a scan signal and a light emitting control signal. As another example, the gate control signals may include a scan signal, a light emitting control signal, and a reset control signal.

In some examples, as shown in FIG. 1, the first direction X may be an extension direction (row direction) of the gate lines GL in the display region AA, and the second direction Y may be an extension direction (column direction) of the data lines DL in the display region AA. The first direction X intersects with the second direction Y, for example, the first direction X and the second direction Y are perpendicular to each other.

In some examples, a pixel unit of the display region AA may include three sub-pixels which are a red sub-pixel, a green sub-pixel, and a blue sub-pixel respectively. However, the embodiment is not limited thereto. In some examples, one pixel unit may include four sub-pixels, and the four sub-pixels are a red sub-pixel, a green sub-pixel, a blue sub-pixel, and a white sub-pixel respectively.

In some examples, a shape of a sub-pixel may be a rectangle, a rhombus, a pentagon, or a hexagon. When one pixel unit includes three sub-pixels, the three sub-pixels may be arranged in parallel in a horizontal direction, in parallel in a vertical direction, or in a manner like a Chinese character " 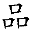 "; when one pixel unit includes four sub-pixels, the four sub-pixels may be arranged in parallel in a horizontal direction, in parallel in a vertical direction, or in a shape of a square. However, the embodiment is not limited thereto.

In some examples, one sub-pixel may include a pixel circuit, and a light emitting element electrically connected with the pixel circuit. The pixel circuit may include multiple transistors and at least one capacitor. For example, the pixel circuit may be a circuit of a 3T1C, 4T1C, 5T1C, 5T2C, 6T1C, 7T1C, or 8T1C structure. Among them, in the above circuit structure, T refers to a thin film transistor, C refers to a capacitor, a number before T represents a quantity of thin film transistors in the circuit, and a number before C represents a quantity of capacitors in the circuit.

In some examples, the plurality of transistors in the pixel circuit may be P-type transistors or may be N-type transistors. Use of a same type of transistors in the pixel circuit may simplify a process flow, reduce a process difficulty of the display substrate, and improve a yield of products. In some other examples, the plurality of transistors in the pixel circuit may include a P-type transistor and an N-type transistor.

In some examples, low temperature poly silicon thin film transistors, or oxide thin film transistors, or both a low temperature poly silicon thin film transistor(s) and an oxide thin film transistor(s) may be used as the plurality of transistors in the pixel circuit. Low Temperature Poly Silicon (LTPS) is used for an active layer of a low temperature poly silicon thin film transistor, and an oxide semiconductor (Oxide) is used for an active layer of an oxide thin film transistor. The low temperature poly silicon thin film transistor has advantages such as a high migration rate and fast charging, and the oxide thin film transistor has advantages such as a low leakage current. The low temperature poly silicon thin film transistor and the oxide thin film transistor are integrated on one display substrate, that is, an LTPS + Oxide (LTPO for short) display substrate, advantages of both the low temperature poly silicon thin film transistor and the oxide thin film transistor may be utilized, so that low-frequency drive can be achieved, power consumption can be reduced, and display quality can be improved.

In some examples, the light emitting element may be any of a Light Emitting Diode (LED), an Organic Light Emitting Diode (OLED), a Quantum dot Light Emitting Diode (QLED), a micro LED (including: mini-LED or micro-LED), and the like. For example, the light emitting element may be an OLED, and the light emitting element may emit red light, green light, blue light, or white light, etc. under driving of a pixel circuit corresponding to the light emitting element. A color of light emitted by the light emitting element may be determined as required. In some examples, the light emitting element may include an anode, a cathode, and an organic emitting layer located between the anode and the cathode. The anode of the light emitting element may be electrically connected to a corresponding pixel circuit. However, the embodiment is not limited thereto.

In some implementations, taking mobile phones or other portable electronic products as an example, because users will carry electric charges when using mobile phones, touching the screens of the mobile phones for a long time and with a high frequency will cause electric charge accumulation on the screens. If the electric charges of the mobile phones cannot be released in time, the screens will work under the electric field. If an antistatic ability of a screen itself is not strong, the screen will display abnormally, which will cause a decrease in customer evaluation and affect user experience. Therefore, when display products are designed, it is necessary to consider more harsh conditions, such as how to achieve normal display in a high electrostatic field.

FIG. 2 is a schematic diagram showing operation of a display substrate under an electrostatic field. As shown in FIG. 2, when the display substrate works under the condition of a high electrostatic field, the electric charges on the display substrate tend to gather from the middle to the periphery of the display substrate. As static electricity accumulates, the gate drive circuit located in the peripheral region will work under the high electrostatic field environment. If the antistatic ability of the gate drive circuit is insufficient, the transistor characteristics of the gate drive circuit will be positively biased by the accumulated charges, which will affect a working state of the gate drive circuit and cause abnormal display of the display substrate.

The present embodiment provides a display substrate including a substrate, a Bottom Shielding Metal (BSM) layer (bottom metal layer), and a gate drive circuit. The base substrate includes a display region and a peripheral region located on a periphery of the display region. The bottom metal layer is located in the peripheral region and electrically connected with at least one kind of signal lines. The gate drive circuit is located in the peripheral region and on one side of the bottom metal layer away from the base substrate. The gate drive circuit includes a plurality of first circuit units. An orthographic projection of the bottom metal layer on the base substrate is at least partially overlapped with an orthographic projection of the at least one first circuit unit on the base substrate. For example, the orthographic projection of the bottom metal layer on the base substrate may cover an orthographic projection of one or more first circuit units on the base substrate, or the orthographic projection of the bottom metal layer on the base substrate may be partially overlapped with the orthographic projection of one or more first circuit units on the base substrate.

In some examples, the at least one kind of signal lines may include at least one of peripheral power supply traces, clock signal lines, first pixel power supply traces. For example, the first pixel power supply traces may be located in a display region and configured to transmit a stable first voltage signal with a constant voltage. The peripheral power supply traces may be located on one side of the gate drive circuit away from the display region and configured to transmit a stable second voltage signal with a constant voltage. The clock signal lines may be located in the peripheral region and configured to transmit pulse signals. In this example, the bottom metal layer is set to receive the stable electrical signals or pulse signals with constant voltages, which can provide a static electricity release path, avoid the static electricity accumulation, and is beneficial to improving the antistatic ability of the gate drive circuit.

In some examples, the bottom metal layer may include a plurality of first metal blocks, wherein the plurality of first metal blocks may be electrically connected with s same kind of signal lines, or at least two first metal blocks may be electrically connected with different kinds of signal lines. As another example, the bottom metal layer may include a plurality of first metal blocks and a plurality of second metal blocks, the plurality of first metal blocks may be electrically connected with a same kind of signal lines, the plurality of second metal blocks may be electrically connected with a same kind of signal lines, and the first metal blocks and the second metal blocks may be electrically connected with different kinds of signal lines. As another example, the bottom metal layer may include a plurality of first metal blocks and a plurality of second metal blocks, the plurality of first metal blocks and the plurality of second metal blocks may be electrically connected with a same kind of signal lines. In this example, the same kind of signal lines may be configured to transmit the same signal and the different kinds of signal lines may be configured to transmit different signals.

In the display substrate provided by the embodiment, the bottom metal layer is disposed in the peripheral region, and the bottom metal layer is used to protect the gate drive circuit, so that the stability of the gate drive circuit under static electricity can be improved, and the gate drive circuit can work normally under a condition that the display substrate is in a high static electricity field, thereby improving the antistatic ability of the display substrate. Moreover, the bottom metal layer is electrically connected with the signal lines, which can provide the static electricity release path, avoid the static electricity accumulation, and is beneficial to improving the antistatic ability of the gate drive circuit.

In some exemplary embodiments, the at least one first circuit unit may include at least one transistor. The orthographic projection of the bottom metal layer on the base substrate may be at least partially overlapped with an orthographic projection of an active layer of at least one transistor of the at least one first circuit unit on the base substrate. In some examples, the active layer of at least one transistor includes at least one channel region; and the orthographic projection of the bottom metal layer on the base substrate may cover an orthographic projection of the channel region of the active layer of the at least one transistor on the base substrate. In some other examples, the orthographic projection of the bottom metal layer on the base substrate may cover orthographic projections of the active layers of a plurality of transistors of at least one first circuit unit on the base substrate. In this example, the active layers of the transistors of the gate drive circuit are sheltered by using the bottom metal layer, which can shield static electricity, improve the stability of transistor characteristics of the gate drive circuit under static electricity, and improve the antistatic ability of the display substrate.

In some exemplary embodiments, at least one first circuit unit may at least include an input sub-circuit and a first control sub-circuit. The input sub-circuit may be configured to provide a signal of a shift input terminal to a first shift node under control of a first clock signal line. The first control sub-circuit may be configured to control a potential of a second shift node under control of the first clock signal line and the first shift node. The first control sub-circuit may be electrically connected with the second shift node through a node adapter electrode. The orthographic projection of the bottom metal layer on the base substrate is at least partially overlapped with an orthographic projection of the node adapter electrode on the base substrate. In this example, the second shift node is at least partially sheltered by using the bottom metal layer, which can protect circuit nodes of the gate drive circuit, thereby improving the antistatic ability of the gate drive circuit.

In some exemplary embodiments, the at least one first circuit unit may at least include an input sub-circuit, a first control sub-circuit, and a second control sub-circuit. The input sub-circuit may be configured to provide a signal of the shift input terminal to a first shift node under control of the first clock signal line. The first control sub-circuit may be configured to control a potential of a second shift node under control of the first clock signal line and the first shift node. The second control sub-circuit may be configured to turn on the first shift node and a third shift node under control of a second power supply line. The input sub-circuit, the first control sub-circuit and the second control sub-circuit are electrically connected with the first shift node through a first connection electrode. The orthographic projection of the bottom metal layer on the base substrate is at least partially overlapped with an orthographic projection of the first connection electrode on the base substrate. In this example, the first shift node is at least partially sheltered by using the bottom metal layer, which can protect the circuit nodes of the gate drive circuit, thereby improving the antistatic ability of the gate drive circuit.

In some exemplary embodiments, the at least one first circuit unit may at least include a second control sub-circuit and an output sub-circuit. The second control sub-circuit may be configured to turn on a first shift node and a third shift node under control of a second power supply line. The output sub-circuit may be configured to control an output signal of the shift output terminal under control of a second shift node and the third shift node. The second control sub-circuit and the output sub-circuit may be electrically connected with the third shift node through the seventh connection electrode. The orthographic projection of the bottom metal layer on the base substrate may cover an orthographic projection of the seventh connection electrode on the base substrate. In this example, the third shift node is sheltered by using the bottom metal layer, which can protect the circuit nodes of the gate drive circuit, thus improving the antistatic ability of the gate drive circuit.

In some example embodiments, the at least one first circuit unit may include at least one capacitor. The orthographic projection of the bottom metal layer on the base substrate may be at least partially overlapped with an orthographic projection of the at least one capacitor of the at least one first circuit unit on the base substrate. In this example, the capacitor of the gate drive circuit is at least partially sheltered by using the bottom metal layer, which is beneficial to increasing node capacitance of a circuit node connected with the capacitor, thereby improving the stability of the circuit node(s). Moreover, the capacitance increased by overlapping the bottom metal layer with the capacitor can be used to reduce space occupied by the capacitor, which is beneficial to reducing a size of the capacitor.

In some exemplary embodiments, the bottom metal layer may include a plurality of first metal blocks, wherein an orthographic projection of at least one first metal block on the base substrate may be at least partially overlapped with an orthographic projection of one or more first circuit units on the base substrate. The plurality of first metal blocks may be of an integral structure and electrically connected with a same kind of signal lines. In some examples, the integral structure formed by the plurality of first metal blocks may be a planar metal block that is not provided with a hollow. In this example, by sheltering the gate drive circuit in a large area, the antistatic ability of the gate drive circuit can be improved, and the preparation process can be simplified. In this example, an integral structure of A and B refers to a structure which A and B are connected to each other to form integrally.

In some exemplary embodiments, the gate drive circuit may include a plurality of cascaded first circuit units and a plurality of cascaded second circuit units. The plurality of cascaded second circuit units may be located on one side of the plurality of cascaded first circuit units away from the display region. The orthographic projection of the bottom metal layer on the base substrate may be at least partially overlapped with an orthographic projection of at least one second circuit unit on the base substrate. For example, the bottom metal layer may include a plurality of first metal blocks and a plurality of second metal blocks; and the plurality of second metal blocks may be located on one side of the plurality of first metal blocks away from the display region. An orthographic projection of at least one first metal block on the base substrate may be at least partially overlapped with an orthographic projection of one or more first circuit units on the base substrate. An orthographic projection of at least one of the plurality of second metal blocks on the base substrate may be at least partially overlapped with an orthographic projection of one or more second circuit units on the base substrate. The plurality of second metal blocks may be of an integral structure, and the plurality of second metal blocks and the plurality of first metal blocks may be electrically connected with different kinds of signal lines. For example, the plurality of second metal blocks are electrically connected with a same kind of signal lines, and the plurality of first metal blocks are electrically connected to the same kind of signal lines. The second metal blocks and the first metal blocks may be configured to receive different signals. For example, an orthographic projection of a second metal block on the base substrate may cover orthographic projections of active layers of a plurality of transistors of at least one second circuit unit on the base substrate. In this example, the second metal block of the bottom metal layer is used to shelter the second circuit unit of the gate drive circuit, so that static electricity can be shielded, thereby improving the antistatic ability of the gate drive circuit.

In some exemplary embodiments, the display region may be provided with a plurality of pixel circuits, wherein the plurality of pixel circuits are electrically connected with at least one first pixel power supply trace, and at least one first metal block is electrically connected with a first power supply trace close to the peripheral region. In some examples, the display region may be provided with a plurality of pixel metal blocks, wherein the plurality of pixel metal blocks and the first metal block may be in a same layer structure. At least one pixel metal block is electrically connected with the first pixel power supply traces, and the at least one first metal block may be electrically connected with the first pixel power supply traces through at least one pixel metal block to receive a stable first voltage signal with a constant voltage transmitted by the first pixel power supply traces. In this example, the first metal block receives the stable first voltage signal with the constant voltage, which can provide a static electricity release path, avoid the static electricity accumulation, and is beneficial to improving the antistatic ability of the gate drive circuit.

In some exemplary embodiments, edges of the bottom metal layer include at least one of the following: a convex corner, a concave corner. At least one of the convex corner and the concave corner may be a rounded corner. In this example, the risk of static electricity in the process can be reduced by rounding the edges of the bottom metal layer.

Solutions of the embodiments will be described below through some examples.

In some examples, the gate drive circuit of the peripheral region may include a scan drive circuit. The scan drive circuit may be configured to generate scan signals supplied to scan lines of the display region. For example, the scan drive circuit may sequentially provide scan signals with on-level pulses to scan lines. The gate drive circuit may include a plurality of cascaded scan drive sub-circuits. An input terminal of a scan drive sub-circuit at a first stage may be electrically connected with a scan start signal line GSTV, and an output terminal of a scan drive sub-circuit at an i-th stage may be electrically connected with an input terminal of a scan drive sub-circuit at an (i+1)-th stage, where i may be a positive integer. In some examples, the plurality of cascaded first circuit units included in the gate drive circuit may be a plurality of cascaded scan drive sub-circuits.

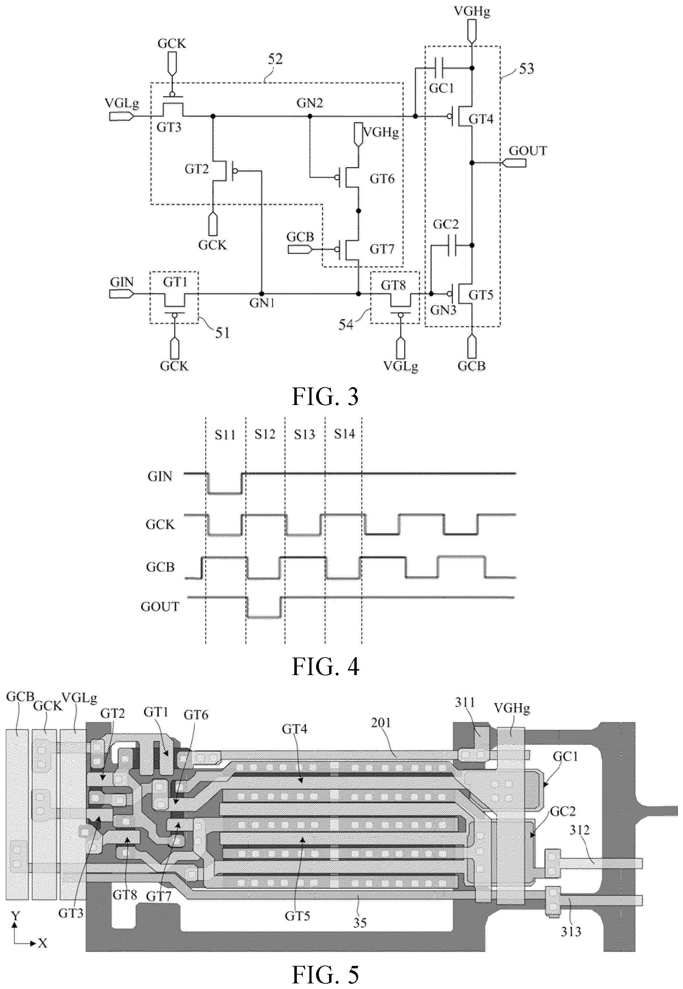

In the following, illustration is made by taking an example in which a first circuit unit is a scan drive sub-circuit. FIG. 3 is an equivalent circuit diagram of a scan drive sub-circuit according to at least one embodiment of the present disclosure. In some examples, as shown in FIG. 3, the scan drive sub-circuit may include: an input sub-circuit 51, a first control sub-circuit 52, a second control sub-circuit 54, and an output sub-circuit 53. The input sub-circuit 51 is electrically connected with a first clock signal line GCK, a shift input terminal GIN, and a first shift node GN1, and the input sub-circuit 51 is configured to provide a signal of the shift input terminal GIN to the first shift node GN1 under control of the first clock signal line GCK. The first control sub-circuit 52 is electrically connected with the first clock signal line GCK, the first shift node GN1, and a second shift node GN2, and the first control sub-circuit 52 is configured to control a potential of the second shift node GN2 under control of the first clock signal line GCK and the first shift node GN1. The second control sub-circuit 54 is electrically connected with a second power supply line VGLg, the first shift node GN1, and the third shift node GN3, and the second control sub-circuit 54 is configured to turn on the first shift node GN1 and a third shift node GN3 under control of the second power supply line VGLg. The output sub-circuit 53 is electrically connected with the second shift node GN2, the third shift node GN3 and a shift output terminal GOUT, and the output sub-circuit 53 is configured to control an output signal of the shift output terminal GOUT under control of the second shift node GN2 and the third shift node GN3.

In some examples, as shown in FIG. 3, the input sub-circuit 51 may include a first shift transistor GT1; the first control sub-circuit 52 may include a second shift transistor GT2, a third shift transistor GT3, a sixth shift transistor GT6, and a seventh shift transistor GT7; the second control sub-circuit 54 may include an eighth shift transistor GT8; and the output sub-circuit 53 may include a fourth shift transistor GT4, a fifth shift transistor GT5, a first shift storage capacitor GC1, and a second shift storage capacitor GC2. Herein, the fourth shift transistor GT4 and the fifth shift transistor GT5 are output transistors of the scan drive sub-circuit.

In some examples, as shown in FIG. 3, a control electrode of the first shift transistor GT1 is electrically connected with the first clock signal line GCK, a first electrode of the first shift transistor GT1 is electrically connected with a shift input terminal GIN, and a second electrode of the first shift transistor GT1 is electrically connected with a first shift node GN1. A control electrode of the second shift transistor GT2 is electrically connected with the first shift node GN1, a first electrode of the second shift transistor GT2 is electrically connected with a first clock signal line GCK, and a second electrode of the second shift transistor GT2 is electrically connected with a second shift node GN2. A control electrode of the third shift transistor GT3 is electrically connected with the first clock signal line GCK, a first electrode of the third shift transistor GT3 is electrically connected with a second power supply line VGLg, and a second electrode of the third shift transistor GT3 is electrically connected with the second shift node GN2. A control electrode of the fourth shift transistor GT4 is electrically connected with the second shift node GN2, a first electrode of the fourth shift transistor GT4 is electrically connected with a first power supply line VGHg, and a second electrode of the fourth shift transistor GT4 is electrically connected with the shift output terminal GOUT. A control electrode of the fifth shift transistor GT5 is electrically connected with a third shift node GN3, a first electrode of the fifth shift transistor GT5 is electrically connected with a second clock signal line GCB, and a second electrode of the fifth shift transistor GT5 is electrically connected with the shift output terminal GOUT. A control electrode of the sixth shift transistor GT6 is electrically connected with the second shift node GN2, a first electrode of the sixth shift transistor GT6 is electrically connected with the first power supply line VGHg, and a second electrode of the sixth shift transistor GT6 is electrically connected with a first electrode of the seventh shift transistor GT7. A control electrode of the seventh shift transistor GT7 is electrically connected with a second clock signal line GCB, and a second electrode of the seventh shift transistor GT7 is electrically connected with the first shift node GN1. A control electrode of the eighth shift transistor GT8 is electrically connected with a second power supply terminal VGLg, a first electrode of the eighth shift transistor GT8 is electrically connected with the first shift node GN1, and a second electrode of the eighth shift transistor GT8 is electrically connected with the third shift node GN3. A second electrode of the first shift storage capacitor GC1 is electrically connected with the first power supply line VGHg, and a first electrode of the first shift storage capacitor GC1 is electrically connected with the second shift node GN2. A second electrode of the second shift storage capacitor GC2 is electrically connected with the shift output terminal GOUT, and a first electrode of the second shift storage capacitor GC2 is electrically connected with the third shift node GN3.

In this example, as shown in FIG. 3, the first shift node GN1 is a connection point of the first shift transistor GT1, the second shift transistor GT2, the seventh shift transistor GT7, and the eighth shift transistor GT8. The second shift node GN2 is a connection point of the second shift transistor GT2, the third shift transistor GT3, the fourth shift transistor GT4, the sixth shift transistor GT6, and the first shift storage capacitor GC1. The third shift node GN3 is a connection point of the eighth shift transistor GT8, the fifth shift transistor GT5, and the second shift storage capacitor GC2.

In some examples, the first shift transistor GT1 to the eighth shift transistors GT8 of the scan drive sub-circuit shown in FIG. 3 may all be P-type transistors or N-type transistors. However, the embodiment is not limited thereto.

In some examples, illustration is made by taking an example in which the first shift transistor GT1 to the eighth shift transistor GT8 of the scan drive sub-circuit shown in FIG. 3 are all P-type transistors. Illustration is made by taking an example in which the shift input terminal GIN of the scan drive sub-circuit in the first stage is electrically connected with a scan start signal line GSTV. FIG. 4 is an operating timing diagram of a scan drive sub-circuit of the scan drive circuit shown in FIG. 3. As shown in FIG. 3 and FIG. 4, the scan drive sub-circuit of this exemplary embodiment may include eight transistor units (i.e., the first shift control transistor GT1 to the eighth shift control transistor GT8), two capacitor units (i.e., the first shift storage capacitor GC1 to the second shift storage capacitor GC2), three input terminals (i.e., the first clock signal line GCK, the second clock signal line GCB and the shift input terminal GIN), one output terminal (i.e., the shift output terminal GOUT), and two power supply terminals (i.e., the first power supply line VGHg and the second power supply line VGLg).The first power supply line VGHg may be configured to continuously provide a high level signal, and the second power supply line VGLg may be configured to continuously provide a low level signal.

In some examples, as shown in FIGS. 3 and 4, the operation process of the scan drive sub-circuit of the scan drive circuit of the present example may include the following phases.

In a first phase S11, the first clock signal line GCK provides a first clock signal with a low level, the shift input terminal GIN receives a trigger signal with a low level, therefore, the first shift transistor GT1 and the third shift transistor GT3 are turned on, and the turned-on first shift transistor GT1 transmits a trigger signal with a low level to the first shift node GN1, such that a level of the first shift node GN1 becomes a low level, so the second shift transistor GT2 and the fifth shift transistor GT5 are turned on. Since the eighth shift transistor GT8 is always in a turned-on state in response to a second voltage (a continuous low level) provided by the second power supply line VGLg, the level of the third shift node GN3 may be the same as that of the first shift node GN1, i.e. the low level, and at the same time this low level is stored in the second shift storage capacitor GC2. In addition, the turned-on third shift transistor GT3 transmits the second voltage with the low level to the second shift node GN2, the turned-on second shift transistor GT2 transmits the low level of the first clock signal to the second shift node GN2, such that the level of the second shift node GN2 becomes a low level, and is stored in the first shift storage capacitor GC1, therefore, the fourth shift transistor GT4 is turned-on in response to the low level of the second shift node GN2. A first voltage with a high level provided by the first power supply line VGHg is output to the shift output terminal GOUT, and meanwhile, the fifth shift transistor GT5 is turned-on in response to the low level of the third shift node GN3, so as to transmit a second clock signal with a high level provided by the second clock signal line GCB to the shift output terminal GOUT, such that the first circuit unit outputs a high level signal in this phase.

In a second phase S12, the second clock signal line GCB provides a second clock signal with a low level, so the seventh shift transistor GT7 is turned on, and the first clock signal line GCK provides a first clock signal with a high level, so the first shift transistor GT1 and the third shift transistor GT3 are turned off. Due to a storage effect of the second shift storage capacitor GC2, the first shift node GN1 may be kept at the low level of the previous phase, so the second shift transistor GT2 and the fifth shift transistor GT5 are turned on. Since the second shift transistor GT2 is turned on, the first clock signal, with the high level, of the first clock signal line GCK is transmitted to the second shift node GN2, such that the level of the second shift node GN2 becomes a high level, and therefore, the sixth shift transistor GT6 and the fourth shift transistor GT4 are turned off, thereby avoiding the high level provided by the first power supply line VGHg from being output to the shift output terminal GOUT and the first shift node GN1. Meanwhile, since the fifth shift transistor GT5 is turned on, in this phase, the shift output terminal GOUT outputs the low level signal transmitted by the second clock signal line GGB.

In a third phase S13, the first clock signal line GCK provides a third clock signal with a low level, so the first shift transistor GT1 and the third shift transistor GT3 are turned on, and at this point, the high level provided by the scan initial signal line GSTV is transmitted from the shift input terminal GIN to the first shift node GN1 and the third shift node GN3, so the fifth shift transistor GT5 and the second shift transistor GT2 are turned off. The second clock signal line GCB receives a second clock signal with a high level, so the seventh shift transistor GT7 is turned off. Since the third shift transistor GT3 is turned on, the low level signal provided by the second power supply line VGLg is transmitted to the second shift node GN2 and stored in the first shift storage capacitor GC1, such that the fourth shift transistor GT4 and the sixth shift transistor GT6 are turned on, and in this phase, the shift output terminal GOUT outputs the high level signal provided by the first power supply line VGHg.

In a fourth phase S14, the first clock signal line GCK provides a first clock signal with a high level, so the first shift transistor GT1 and the third shift transistor GT3 are turned off. The second clock signal line GCB provides a second clock signal with a low level, so the seventh shift transistor GT7 is turned on. Due to a storage effect of the second shift storage capacitor GC2, the level of the first shift node GN1 maintains the high level of the previous phase, such that the second shift transistor GT2 and the fifth shift transistor GT5 are turned off. In this phase, the shift output terminal GOUT outputs a high level signal provided by the first power supply line VGHg. Due to a storage effect of the first shift storage capacitor GC1, the second shift node GN2 continues maintaining the low level of the previous phase, such that the sixth shift transistor GT6 is turned on, then the high level provided by the first power supply line VGHg is transmitted to the first shift node GN1 and the third shift node GN3 through the turned-on sixth shift transistor GT6 and the seventh shift transistor GT7, thus the first shift node GN1 and the third shift node GN3 continue maintaining the high level, and the fifth shift transistor GT5 is effectively prevented from being turned on, thereby avoiding an erroneous output.

In some examples, the scan drive sub-circuit may subsequently repeat the third phase S 13 and the fourth phase S14 till the shift input terminal GIN receives the low level signal again.

FIG. 5 is a schematic partial plan view of a peripheral region according to at least one embodiment of the present disclosure. FIG. 5 illustrates a planar structure of a scan drive sub-circuit as an example.

In some examples, as shown in FIG. 5, the first clock signal line GCK, the second clock signal line GCB, the first power supply line VGHg, and the second power supply line VGLg may all extend in the second direction Y in a plane parallel to the display substrate. The first clock signal line GCK, the second clock signal line GCB, and the second power supply line VGLg may be located on one side of the scan drive sub-circuit away from the display region, and the first power supply line VGHg may be located on one side of the scan drive sub-circuit close to the display region. The first clock signal line GCK may be located between the second clock signal line GCB and the second power supply line VGLg. The first clock signal line GCK may be located on one side of the second clock signal line GCB close to the display region.

In some examples, as shown in FIG. 5, the scan drive sub-circuit may be located between the first power supply line VGHg and the second power supply line VGLg. The first shift storage capacitor GC1 may be located on one side of the fourth shift transistor GT4 close to the first power supply line VGHg, and orthographic projections of the first shift storage capacitor GC1 and the first power supply line VGHg on the base substrate may partly overlapped. The second shift storage capacitor GC2 may be located on one side of the fifth shift transistor GT5 close to the first power supply line VGHg, and orthographic projections of the second shift storage capacitor GC2 and the first power supply line VGHg on the base substrate may partly overlapped. The second shift storage capacitor GC2 and the first shift storage capacitor GC1 may be sequentially arranged along the second direction Y. The fifth shift transistor GT5 and the fourth shift transistor GT4 may be sequentially arranged along the second direction Y. The third shift transistor GT3 may be located on one side of the eighth shift transistor GT8 close to the second power supply line VGLg, and the third shift transistor GT3 and the second shift transistor GT2 may be sequentially arranged along the second direction Y. The first shift transistor GT1 may be located on one side of the second shift transistor GT2 away from the second power supply line VGLg. The seventh shift transistor GT7 may be located on one side of the eighth shift transistor GT8 away from the second power supply line VGLg, and the sixth shift transistor GT6 may be located between the seventh shift transistor GT7 and the first shift transistor GT1 in the second direction Y.

In some examples, in a direction perpendicular to the display substrate, the display substrate of the peripheral region may include a base substrate, a bottom metal layer and a circuit structure layer sequentially disposed on the base substrate, and the circuit structure layer of the peripheral region may include a semiconductor layer, a first conductive layer, a second conductive layer and a third conductive layer sequentially disposed. In some examples, a first insulation layer may be disposed between the bottom metal layer and the semiconductor layer, a second insulation layer may be disposed between the semiconductor layer and the first conductive layer, a third insulation layer may be disposed between the first conductive layer and the second conductive layer, and a fourth insulation layer may be disposed between the second conductive layer and the third conductive layer. The first conductive layer may also be referred to as a first gate metal layer, the second conductive layer may also be referred to as a second gate metal layer, and the third conductive layer may also be referred to as a first source-drain metal layer. In some examples, the first to fourth insulation layers may each be made of an inorganic material. However, the embodiment is not limited thereto. In some examples, a planarization layer, an anode layer, a pixel definition layer, an organic light emitting layer, a cathode layer, and an encapsulating layer may further be sequentially disposed at one side of the third conductive layer of the display region of the display substrate away from the base substrate.

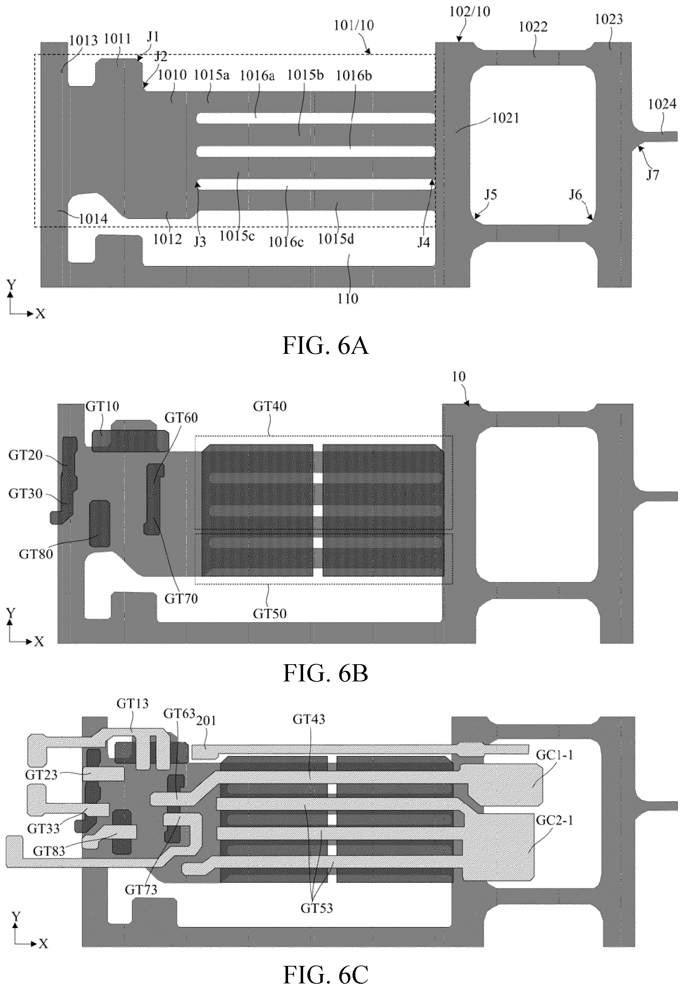

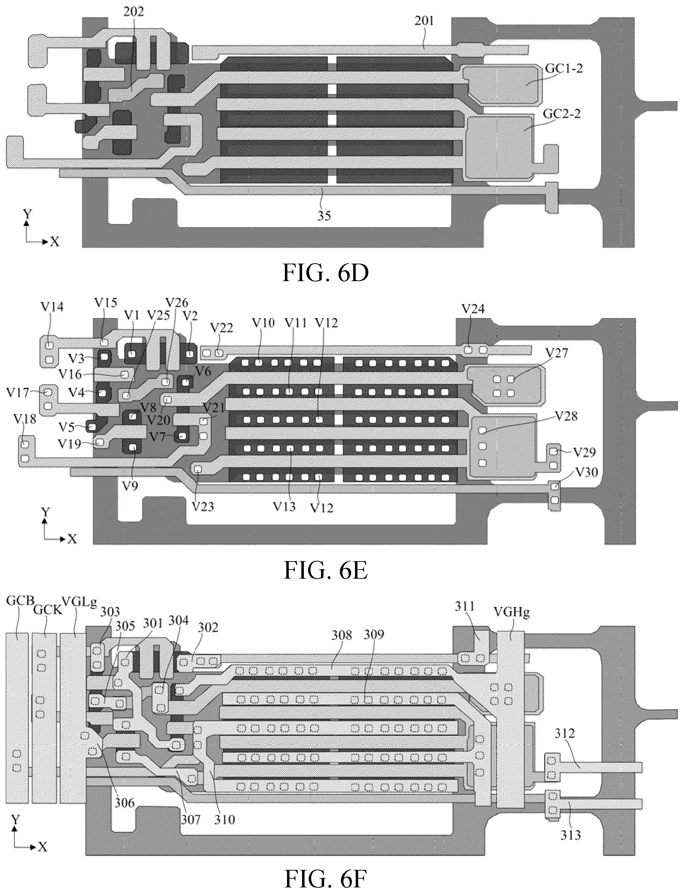

FIG. 6A is a schematic partial plan view of a peripheral region after a bottom metal layer is formed in FIG. 5. FIG. 6B is a schematic partial plan view of a peripheral region after a semiconductor layer is formed in FIG. 5. FIG. 6C is a schematic partial plan view of a peripheral region after the first conductive layer is formed in FIG. 5. FIG. 6D is a schematic partial plan view of a peripheral region after the second conductive layer is formed in FIG. 5. FIG. 6E is a schematic partial plan view of a peripheral region after a fourth insulation layer is formed in FIG. 5. FIG. 6F is a schematic partial plan view of a peripheral region after the third conductive layer is formed in FIG. 5.

In some examples, as shown in FIG. 6A, the bottom metal layer 10 of the peripheral region may include a plurality of first metal blocks 101 (one first metal block 101 is illustrated as an example in FIG. 6A), and a first connection structure 102. The plurality of first metal blocks 101 and the first connection structure 102 may be of an integral structure. The plurality of first metal blocks 101 may be sequentially arranged along the second direction Y, and adjacent first metal blocks 101 may be electrically connected with each other, for example, may be formed into an integral structure. The first metal block 101 may be located on one side of the first connection structure 102 away from the display region. For example, one first metal block 101 may correspond to one scan drive sub-circuit, and the one first metal block 101 may be located below the corresponding scan drive sub-circuit to provide protection to the corresponding scan drive sub-circuit and improve the antistatic capability of the scan drive sub-circuit. However, the embodiment is not limited thereto. In some other examples, one first metal block may correspond to a plurality of scan drive sub-circuits.

In some examples, as shown in FIG. 6A, one first metal block 101 may include a first main body portion 1010, a first extension portion 1011, a second extension portion 1012, a third extension portion 1013, a fourth extension portion 1014, and a plurality of fifth extension portions (e.g. four fifth extension portions 1015a, 1015b, 1015c, and 1015d). For example, an orthographic projection of the first main body portion 1010 on the base substrate may be substantially rectangular in shape. The first extension portion 1011 and the second extension portion 1012 may extend from two opposite sides of the first main body portion 1010 along the second direction Y, and the third extension portion 1013 and the fourth extension portion 1014 may extend from two opposite sides of the first main body portion 1010 along the second direction Y. The first extension portion 1011 and the third extension portion 1013 are adjacent in the first direction X and may protrude from an upper edge of the first main body portion 1010; the second extension portion 1012 and the fourth extension portion 1014 are adjacent in the first direction X and may protrude from a lower edge of the first main body portion 1010. For example, a third extension portion 1013 of one first metal block 10 may be connected with a fourth extension portion of one first metal block adjacent in the second direction Y as an integral structure, and the fourth extension portion 1014 of the first metal block 10 may be connected with a third extension portion of another first metal block adjacent in the second direction Y as an integral structure. The four fifth extension portions 1015a, 1015b, 1015c, and 1015d may extend from the first main body portion 1010 to one side close to the display region along the first direction X, and may protrude from a right edge of the first main body portion 1010. There may be a first hollow portion between adjacent fifth extension portions, for example, a first hollow portion 1016a between fifth extension portions 1015a and 1015b, a first hollow portion 1016b between fifth extension portions 1015b and 1015c, and a first hollow portion 1016c between fifth extension portions 1015c and 1015d. In some examples, edges of the first hollow portions 1016a, 1016b, and 1016c may include concave corners (e.g. corners J3 and J4) that may employ a rounded design, thereby reducing the risk of static electricity generated in the process.

In some examples, as shown in FIG. 6A, a hollow region 110 may be disposed between two adjacent first metal blocks 101. The hollow region 110 may be formed by a second extension portion 1012, a fourth extension portion 1014, and a fifth extension portion 1015d of a first metal block 101, and a third extension portion, a first extension portion, and a fifth extension portion of another first metal block which are around the hollow region 110. In this example, by forming the hollow region between adjacent first metal blocks, the area of the first metal block can be reduced, thereby the risk of static electricity generated in the process can be reduced.

In some examples, as shown in FIG. 6A, the first connection structure 102 may be located on one side of the plurality of first metal blocks 101 close to the display region. The first connection structure 102 is connected with the plurality of fifth extension portions of the first metal block 101 to form an integral structure. The first connection structure 102 may include a first connection segment 1021, a second connection segment 1022, a third connection segment 1023, and a fourth connection segment 1024. The first connection segment 1021 may be connected with a plurality of fifth extension portions of the first metal block 101. The first connection segment 1021 and the third connection segment 1023 may both extend substantially in the second direction Y, and the second connection segment 1022 and the fourth connection segment 1024 may both extend substantially in the first direction X toward one side of the display region. The first connection segment 1021 may be connected with a plurality of first metal blocks 101, such as adjacent first metal blocks 101. A plurality of second connection segments 1022 are connected between the first connection segment 1021 and the third connection segment 1023. The fourth connection segment 1024 may be connected with the third connection segment 1023 and extend along the first direction X toward one side of the display region. The second connection segment 1022 and the fourth connection segment 1024 may be misaligned in the first direction X. For example, the second connection segment 1022 and the fourth connection segment 1024 may be connected in a misaligned manner on two opposite sides of the third connection segment 1023 in the first direction X. The orthographic projection of the first connection structure 102 of this example on the base substrate may be substantially a mesh structure. In this example, it is beneficial to reducing the impedance of the first connection structure 102 by arranging the first connection structure 102 as a mesh structure. However, the embodiment is not limited thereto. In some other examples, the first connection structure 102 may include only a first extension segment extending in the first direction X.

In some examples, as shown in FIG. 6A, the edges of the first metal block 101 may include convex corners (e.g. corner J1) and concave corners (e.g. corner J2). The edges of the first connection structure 102 may include concave corners (e.g. corners J5, J6, and J7). The corners of the edges of the first metal block 101 and the first connection structure 102 may all be designed with rounded corners so that the risk of static electricity generated in the process can be reduced. The edges of the bottom metal layer 10 of the present example may include the edges of the first metal block 101, the edges of a first hollow portion of the first metal block 101, and connection corners between connection segments of the first connection structure. In this example, the corners of the edges of the bottom metal layer may all be designed with rounded corners so that the risk of static electricity in the process can be reduced.

In some examples, as shown in FIG. 6B, a semiconductor layer of the peripheral region may at least include active layers of a plurality of transistors of a scan drive sub-circuit (e.g., an active layer GT10 of the first shift transistor, an active layer GT20 of the second shift transistor, an active layer GT30 of the third shift transistor, an active layer GT40 of the fourth shift transistor, an active layer GT50 of the fifth shift transistor, an active layer GT60 of the sixth shift transistor, an active layer GT70 of the seventh shift transistor, and an active layer GT80 of the eighth shift transistor). The active layer GT20 of the second shift transistor and the active layer GT30 of the third shift transistor may be of an integral structure. The active layer GT60 of the sixth shift transistor and the active layer GT70 of the seventh shift transistor may be of an integral structure. The active layer GT40 of the fourth shift transistor and the active layer GT50 of the fifth shift transistor may be of an integral structure. However, the embodiment is not limited thereto.

In some examples, as shown in FIGS. 6A and 6B, orthographic projections of the active layers of the plurality of transistors of the scan drive sub-circuit on the base substrate may be at least partially overlapped with the orthographic projection of the first metal block 101 on the base substrate. Orthographic projections of the active layer GT60 of the sixth shift transistor, the active layer GT70 of the seventh shift transistor, and the active layer GT80 of the eighth shift transistor on the base substrate may be located within an orthographic projection range of the first metal block 101 on the base substrate, and orthographic projections of the active layers of the remaining shift transistors on the base substrate may be at least partially overlapped with the orthographic projection of the first metal block 101 on the base substrate. For example, an orthographic projection of the active layer GT10 of the first shift transistor on the base substrate is partially overlapped with an orthographic projection of the first extension portion 1011 of the first metal block 101 on the base substrate; orthographic projections of the active layer GT20 of the second shift transistor and the active layer GT30 of the third shift transistor on the base substrate are partially overlapped with an orthographic projection of the first main body portion 1010 on the base substrate; the orthographic projections of the active layer GT60 of the sixth shift transistor, the active layer GT70 of the seventh shift transistor, and the active layer GT80 of the eighth shift transistor on the base substrate are located within the orthographic projection range of the first main body portion 1010 on the base substrate; orthographic projections of the active layer GT40 of the fourth shift transistor and the active layer GT50 of the fifth shift transistor on the base substrate are partially overlapped with orthographic projections of the four fifth extension portions on the base substrate. The shape of the first metal block of the present example may correspond to shapes of a plurality of transistors of the scan drive sub-circuit.

In some examples, as shown in FIG. 6C, a first conductive layer of the peripheral region may include at least: control electrodes of a plurality of transistors of a scan drive sub-circuit (e.g., a control electrode GT13 of the first shift transistor, a control electrode GT23 of the second shift transistor, a control electrode GT33 of the third shift transistor, a control electrode GT43 of the fourth shift transistor, a control electrode GT53 of the fifth shift transistor, a control electrode GT63 of the sixth shift transistor, a control electrode GT73 of the seventh shift transistor, and a control electrode GT83 of the eighth shift transistor), a first electrode GC1-1 of a first shift storage capacitor, a first electrode GC2-1 of a second shift storage capacitor, and an input connection line 201. The input connection line 201 may extend along the first direction X and be located on one side of the active layer GT40 of the fourth shift transistor away from the active layer GT50 of the fifth shift transistor. The control electrode GT63 of the sixth shift transistor, the control electrode GT43 of the fourth shift transistor, and the first electrode GC1-1 of the first shift storage capacitor may be formed into an integral structure. The control electrode GT53 of the fifth shift transistor and the first electrode GC2-1 of the second shift storage capacitor may be formed into an integral structure.

In some examples, an active layer may include at least one channel region and a plurality of doped regions. For example, the doped regions may be located on two opposite sides of the channel region. An orthographic projection of the channel region of the active layer of the transistor may be overlapped with an orthographic projection of a control electrode of the transistor on the base substrate. For example, an orthographic projection of the channel region of the active layer of a transistor on the base substrate may be within an orthographic projection range of the control electrode of the transistor on the base substrate. As shown in FIGS. 6A to 6C, orthographic projections of channel regions of active layers of the plurality of transistors of the scan drive sub-circuit on the base substrate may be within the orthographic projection range of the first metal block 101 on the base substrate. In other words, the orthographic projection of the first metal block 101 on the base substrate may cover the orthographic projections of the channel regions of the active layers of the first shift transistor to the eighth shift transistor of the scan drive sub-circuit on the base substrate. In some examples, the orthographic projection of the first metal block 101 on the base substrate may be partially overlapped with doped regions of an active layer of an output transistor. For example, orthographic projections of doped regions of the active layer GT40 of the fourth shift transistor and the active layer GT50 of the fifth shift transistor on the base substrate are partially overlapped with the orthographic projection of the first metal block 101 on the base substrate, and orthographic projections of three first hollow portions of the first metal block 101 on the base substrate are not overlapped with orthographic projections of channel regions of the active layer GT40 of the fourth shift transistor and the active layer GT50 of the fifth shift transistor on the base substrate. The orthographic projections of the first hollow portions of the first metal block 101 on the base substrate may be partially overlapped with the orthographic projections of the doped regions of the active layer GT40 of the fourth shift transistor and the active layer GT50 of the fifth shift transistor on the base substrate. In this example, the first metal block shelters the channel regions of the active layers of the plurality of transistors of the scan drive sub-circuit, which can shield the influence of the static electricity accumulation of the base substrate side on the transistor characteristics of the scan drive sub-circuit, thereby improving the stability of the scan drive sub-circuit under the static electricity. Furthermore, by providing the first hollow portions in the first metal block, the area of the first metal block can be reduced on the basis of protecting the characteristics of the transistors, and the risk of the static electricity generated in the process can be reduced.

In some examples, as shown in FIG. 6D, the second conductive layer of the peripheral region may at least include a second electrode GC1-2 of the first shift storage capacitor of the scan drive sub-circuit, a second electrode GC2-2 of the second shift storage capacitor, a node adapter electrode 202, and a first output connection line 35. The node adapter electrode 202 may be located between a control electrode GT23 of the second shift transistor and a control electrode GT63 of the sixth shift transistor. An orthographic projection of the second electrode GC1-2 of the first shift storage capacitor on the base substrate is within an orthographic projection of a first electrode GC1-1 of the first shift storage capacitor on the base substrate. An orthographic projection of the second electrode GC2-2 of the second shift storage capacitor on the base substrate may be at least partially overlapped with an orthographic projection of a first electrode GC2-1 of the second shift storage capacitor on the base substrate. The first output connection line 35 may extend along the first direction X and is located on one side of the active layer GT50 of the fifth shift transistor away from the active layer GT40 of the fourth shift transistor.

In some examples, as shown in FIGS. 6A to 6D, orthographic projections of the first shift storage capacitor and the second shift storage capacitor on the base substrate may be partially overlapped with the orthographic projection of the bottom metal layer 10 on the base substrate. For example, the orthographic projections of the first shift storage capacitor and the second shift storage capacitor on the base substrate may be not overlapped with the orthographic projection of the first metal block 101 on the base substrate, and may partially overlap with the orthographic projection of the first connection segment 1021 of the first connection structure 102 on the base substrate. Portions of the first shift storage capacitor and the second shift storage capacitor may be located within a region surrounded and formed by the first connection segment 1021, the second connection segment 1022, and the third connection segment 1023 of the first connection structure 102.

In some examples, as shown in FIG. 6E, the fourth insulation layer of the peripheral region may be provided with a plurality of vias, which may include, for example, a first via V1 to a thirtieth via V30.Fourth insulation layers, third insulation layers and second insulation layers in the first via V1 to the thirteenth via V13 may be etched away to expose partial surface of the semiconductor layer; fourth insulation layers and third insulation layers in the fourteenth via V14 to the twenty-fourth via V24 may be etched away to expose partial surface of the first conductive layer; and fourth insulation layers in the twenty-fifth via V25 to the thirtieth via V30 may be etched away to expose partial surface of the second conductive layer.

In some examples, as shown in FIG. 6F, the third conductive layer of the peripheral region may at least include a plurality of connection electrodes (e.g. a first connection electrodes 301 to a thirteenth connection electrode 313), a first clock signal line GCK, a second clock signal line GCB, a first power supply line VGHg, and a second power supply line VGLg. The first clock signal line GCK, the second clock signal line GCB, the first power supply line VGHg, and the second power supply line VGLg may all extend substantially along the second direction Y.

In some examples, as shown in FIGS. 5 to 6F, the first connection electrode 301 may be electrically connected with a doped region of the active layer GT10 of the first shift transistor through a first via V1, may also be electrically connected with a control electrode GT23 of the second shift transistor through a sixteenth via V16, may also be electrically connected with a doped region of the active layer GT80 of the eighth shift transistor through an eighth via V8, and may also be electrically connected with a doped region of the active layer GT70 of the seventh shift transistor through a seventh via V7. A second connection electrode 302 may be electrically connected with another doped region of the active layer GT10 of the first shift transistor through a second via V2, and may also be electrically connected with one end of the input connection line 201 through two twenty-second vias V22 disposed horizontally. The other end of the input connection line 201 may be electrically connected with an eleventh connection electrode 311 through two twenty-fourth vias V24 disposed horizontally, and the eleventh connection electrode 311 may be electrically connected with a shift output terminal of a scan drive sub-circuit of the previous stage. In some examples, the input connection line 201 may be configured to extend to one side of the display region and electrically connected with a scan line or a reset control line of the display region through a connection line located at the third conductive layer. A third connection electrode 303 may be electrically connected with a doped region of an active layer GT20 of a second shift transistor through a third via V3, and may also be electrically connected with a control electrode GT13 of a first shift transistor through a fifteenth via V15. A control electrode GT13 of the first shift transistor is electrically connected with the first clock signal line GCK through two fourteen vias V14 disposed vertically. A fourth connection electrode 304 may be electrically connected with a control electrode GT63 of a sixth shift transistor through a twentieth via V20, and may also be electrically connected with the node adapter electrode 202 through a twenty-sixth via V26. A fifth connection electrode 305 may be electrically connected with another doped region of the active layer GT20 of the second shift transistor through a fourth via V4, and may also be electrically connected with the node adapter electrode 202 through a twenty-fifth via V25. A sixth connection electrode 306 may be electrically connected with a doped region of an active layer GT30 of a third shift transistor through a fifth via V5, and may also be electrically connected with a control electrode GT83 of an eighth shift transistor through the ninteenth via V19. The sixth connection electrode 306 and the second power supply line VGLg may be formed into an integral structure. A control electrode of the third shift transistor is electrically connected with the first clock signal line GCK through two seventeenth vias V17 disposed vertically. A seventh connection electrode 307 may be electrically connected with another doped region of an active layer GT80 of the eighth shift transistor through a ninth via V9, and may also be electrically connected with a control electrode GT53 of the fifth shift transistor through a twenty-third via V23. An eighth connection electrode 308 may be electrically connected with a doped region of an active layer GT40 of a fourth shift transistor through a plurality of tenth vias V10 disposed horizontally, and may also be electrically connected with one doped region of an active layer GT60 of the sixth shift transistor through a sixth via V6. The eighth connection electrode 308 and the first power supply line VGHg may be formed into an integral structure. The first power supply line VGHg may be electrically connected with the second electrode GC1-2 of the first shift storage capacitor through a plurality of twenty-seventh vias V27. A ninth connection electrode 309 may be electrically connected with a doped region of an active layer GT40 of the fourth shift transistor through a plurality of eleventh vias V11, may also be electrically connected with a doped region of an active layer GT50 of the fifth shift transistor through a plurality of thirteenth vias V13, and may also be electrically connected with a second electrode GC2-2 of the second shift storage capacitor through three twenty-eighth vias V28 disposed vertically. The ninth connection electrode 309 as a shift output terminal of a scan drive sub-circuit of the current stage may be electrically connected with an eleventh connection electrode 311 of a scan drive sub-circuit of a next stage and the input connection line 201. A tenth connection electrode 310 may be electrically connected with a doped region of the active layer GT50 of the fifth shift transistor through a plurality of twelfth vias V12, and may also be electrically connected to a control electrode GT73 of the seventh shift transistor through two twenty-first vias V21 disposed vertically. The control electrode GT73 of the seventh shift transistor is electrically connected with the second clock signal line GCB through two eighteenth vias V18 disposed vertically. A twelfth connection electrode 312 may be electrically connected with the second electrode GC2-2 of the second shift storage capacitor through two twenty-ninth vias V29 disposed vertically. The twelfth connection electrode 312 may extend toward a side of the display region so as to be electrically connected with a scan line of the display region and configured to provide a scan signal to a row of pixel circuits. A thirteenth connection electrode 313 may be electrically connected with the first output connection line 35 through two thirtieth vias V30 disposed vertically. The thirteenth connection electrode 313 may extend to a side of the display region, for example electrically connected with a light emitting control line of the display region, and the thirteenth connection electrode 313 may be configured to provide a light emitting control signal to a row of pixel circuits. For example, the first output connection line 35 may be electrically connected with a light emitting control sub-circuit disposed on the side of the scan drive sub-circuit away from the display region. The orthographic projection of the first output connection line 35 on the base substrate may be partially overlapped with an orthographic projection of a hollow region 110 between adjacent first metal blocks 101 on the base substrate. In this example, by providing the hollow region, an area overlapped between the first output connection line and the first metal block can be reduced, an influence of a parasitic capacitance between the first output connection line and the first metal block on signal transmission of the first output connection line can be reduced, and on the basis of the a stability of the signal transmission of the first output connection line, the area of the first metal block can be reduced, and the static electricity risk generated in the process can be reduced.

In some examples, the control electrode GT63 of the sixth shift transistor GT6 can be electrically connected with the second shift transistor GT2 and the third shift transistor GT3, i.e., the second shift node GN2, through the node adapter electrode 202. An orthographic projection of the node adapter electrode 202 on the base substrate may be located within the orthographic projection range of the first metal block 101 on the base substrate, so that the second shift node GN2 in the scan drive sub-circuit can be covered by using the first metal block 101 to shield an influence of the static electricity on the second shift node GN2, and the capacitance formed between the first metal block 101 and the node adapter electrode 202 can increase a node capacitance and improve the stability of the second shift node GN2. An electrical connection of the first shift transistor GT1, the second shift transistor GT2, the seventh shift transistor GT7 and the eighth shift transistor GT8, i.e., an electrical connection with the first shift node GN1, can be realized by the first connection electrode 301. An orthographic projection of the first connection electrode 301 on the base substrate may be located within the orthographic projection range of the first metal block 101 on the base substrate, so that the first shift node GN1 in the scan drive sub-circuit can be covered by using the first metal block 101, and an influence of the static electricity on the first shift node GN1 can be shielded. The seventh connection electrode 307 may realize an electrical connection of the eighth shift transistor GT8, the fifth shift transistor GT5, and the second shift storage capacitor GC2, i.e., an electrical connection with the third shift node GN3. An orthographic projection of the seventh connection electrode 307 on the base substrate may be within the orthographic projection range of the first metal block 101 on the base substrate, so that the third shift node GN3 in the scan drive sub-circuit can be covered by using the first metal block 101, and an influence of the static electricity on the third shift node GN3 can be shielded.

In some examples, the display region may be provided with a plurality of pixel circuits, wherein at least one pixel circuit is electrically connected with first pixel power supply traces. A first metal block of the peripheral region may be electrically connected with the first pixel power supply traces of the display region, to be configured to receive a first voltage signal. For example, a first connection structure of the bottom metal layer of the peripheral region may extend to the display region, and be directly electrically connected with at least one first pixel power supply trace within the display region close to the peripheral region. In another example, a plurality of pixel metal blocks may be disposed in the display region, the pixel metal blocks may be in a same layer structure with the first metal block in the peripheral region, and the first metal block may be electrically connected with the first pixel power supply traces through the pixel metal blocks. This embodiment is not limited thereto.

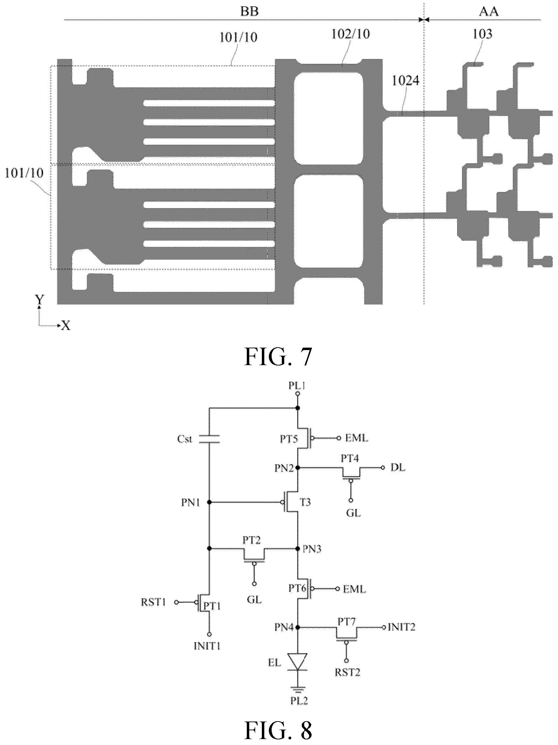

FIG. 7 is a schematic partial view of a display region and a peripheral region according to at least one embodiment of the present disclosure. In some examples, as shown in FIG. 7, the bottom metal layer 10 of the display substrate may at least include a plurality of first metal blocks 101 (taking two first metal blocks 101 as an example in FIG. 7) and a first connection structure 102 located in a peripheral region BB, and a plurality of pixel metal blocks 103 located in the display region AA. A plurality of pixel metal blocks 103 may be arranged in an array and connected as an integral structure. The first connection structure 102 of the peripheral region BB may be directly connected with the pixel metal blocks 103 of the display region AA as an integral structure. For example, the fourth connection segment 1024 of the first connection structure 102 is directly connected with the pixel metal block 103.

In some examples, the pixel metal blocks 103 of the display region may extend to the upper and lower bezels of the peripheral region of the display substrate, and be electrically connected with a fifth power supply line PL1 or a sixth power supply line PL2. In some examples, a first pixel power supply trace may be the fifth power supply line PL1, the first metal block 101 may be electrically connected with the pixel metal block 103 through the first connection structure 102, and the pixel metal block 103 may be electrically connected with the fifth power supply line PL1 such that the first metal block 101 receives a stable first voltage signal with a constant voltage provided by the fifth power supply line PL1. However, the embodiment is not limited thereto. In some other examples, the first connection structure 102 may be electrically connected with a first power supply line VGHg located in the peripheral region, for example, a second connection segment 1022 of the first connection structure 102 may be electrically connected with the first power supply line VGHg, to enable the first metal block to receive a stable electrical signal with a constant voltage transmitted by the first power supply line VGHg, providing an electrostatic discharge path. However, the embodiment is not limited thereto.

In some examples, as shown in FIG. 7, the first connection structure 102 within the perimeter region BB may be substantially a mesh structure which can reduce an impedance of the bottom metal layer.

FIG. 8 is an equivalent circuit diagram of a pixel circuit of a display region according to at least one embodiment of the present disclosure. The pixel circuit of this example is a 7T1C structure. In some examples, as shown in FIG.8, the pixel circuit may include six switching transistors (PT1, PT2, and PT4 to PT7), one drive transistor PT3, and one pixel storage capacitor Cst. The six switching transistors are respectively a data writing transistor PT4, a threshold compensation transistor PT2, a first light emitting control transistor PT5, a second light emitting control transistor PT6, a first reset transistor PT1, and a second reset transistor PT7. A light emitting element EL may include an anode, a cathode, and an organic emitting layer disposed between the anode and the cathode.

In some examples, the drive transistor and the six switching transistors may be P-type transistors or may be N-type transistors. Adopting a same type of transistors in a pixel circuit can simplify a process flow, reduce a process difficulty of a display substrate, and improve a yield of products. In some exemplary implementations, the drive transistor and the six switching transistors may include a P-type transistor and an N-type transistor.

In some examples, as shown in FIG. 8, a pixel circuit is connected with a scan line GL, a data line DL, a fifth power supply line PL1, a sixth power supply line PL2, a light emitting control line EML, a first initial voltage line INIT1, a second initial voltage line INIT2, a first reset control line RST1, and a second reset control line RST2. In some examples, the fifth power supply line PL1 is configured to provide a constant first voltage signal VDD for a pixel circuit, the sixth power supply line PL2 is configured to provide a constant second voltage signal VSS to a pixel circuit, wherein the first voltage signal VDD may be greater than the second voltage signal VSS. The scan line GL may be configured to provide a scan signal SCAN to the pixel circuit, the data line DL may be configured to provide a data signal DATA to the pixel circuit, the light emitting control line EML may be configured to provide a light emitting control signal EM to the pixel circuit, the first reset control line RST1 is configured to provide a first reset control signal RESET1 to the pixel circuit, and the second reset control line RST2 is configured to provide a second reset control signal RESET2 to the pixel circuit. In some examples, a second reset signal RESET2 (i) received by the pixel circuit in an i-th row is a scan signal SCAN (i) received by the pixel circuit in the i-th row. However, the embodiment is not limited thereto.

In some examples, the scan drive sub-circuit in the i-th stage in the above embodiments may provide a scan signal for the pixel circuit in i-th row through the scan line GL, and may also provide a second reset control signal for the pixel circuit in the i-th row through the second reset control line, and may also provide a first reset control signal for the pixel circuit in the (i-1)-th row through the first reset control line. The light emitting drive circuit may provide a light emitting control signal to at least one row of pixel circuits in the display region through a light emitting control line EML. However, the embodiment is not limited thereto.

In some examples, as shown in FIG. 8, a control electrode of the data writing transistor PT4 is electrically connected with the scan line GL, a first electrode of the data writing transistor PT4 is electrically connected with the data line DL, and a second electrode of the data writing transistor PT4 is electrically connected with a first electrode of the drive transistor PT3. A control electrode of the threshold compensation transistor PT2 is electrically connected with the scan line GL, a first electrode of the threshold compensation transistor PT2 is electrically connected with the control electrode of the drive transistor PT3, and a second electrode of the threshold compensation transistor PT2 is electrically connected with a second electrode of the drive transistor PT3. A control electrode of the first light emitting control transistor PT5 is electrically connected with the light emitting control line EML, a first electrode of the first light emitting control transistor PT5 is connected with the fifth power supply line PL1, and a second electrode of the first light emitting control transistor PT5 is connected with the first electrode of the drive transistor PT3. A control electrode of the second light emitting control transistor PT6 is electrically connected with the light emitting control line EML, a first electrode of the second light emitting control transistor PT6 is electrically connected with the second electrode of the drive transistor PT3, and a second electrode of the second light emitting control transistor PT6 is electrically connected with an anode of the light emitting element EL. The first reset transistor PT1 is electrically connected to the control electrode of the drive transistor PT3 and configured to reset the control electrode of the drive transistor PT3, and the second reset transistor PT7 is electrically connected to the anode of the light emitting element EL and configured to reset the anode of the light emitting element EL. A control electrode of the first reset transistor PT1 is electrically connected to the first reset control line RST1, a first electrode of the first reset transistor PT1 is electrically connected to a first initial voltage line INIT1, and a second electrode of the first reset transistor PT1 is electrically connected to the control electrode of the drive transistor PT3. A control electrode of the second reset transistor PT7 is electrically connected to a second reset control line RST2, a first electrode of the second reset transistor PT7 is electrically connected to the second initial voltage line INIT2, and a second electrode of the second reset transistor PT7 is electrically connected to the anode of the light emitting element EL. A first electrode of the pixel storage capacitor Cst is electrically connected with the control electrode of the drive transistor PT3, and a second electrode of the pixel storage capacitor Cst is electrically connected with the fifth power supply line PL1.

In this example, as shown in FIG. 8, a first pixel node PN1 is a connection point of the pixel storage capacitor Cst, the first reset transistor PT1, the drive transistor PT3, and the threshold compensation transistor PT2; a second pixel node PN2 is a connection point of the first light emitting control transistor PT5, the data writing transistor PT4, and the drive transistor PT3; a third pixel node PN3 is a connection point of the drive transistor PT3, the threshold compensation transistor PT2, and the second light emitting control transistor PT6; and a fourth pixel node PN4 is a connection point of the second light emitting control transistor PT6, the second reset transistor PT7, and the light emitting element EL.

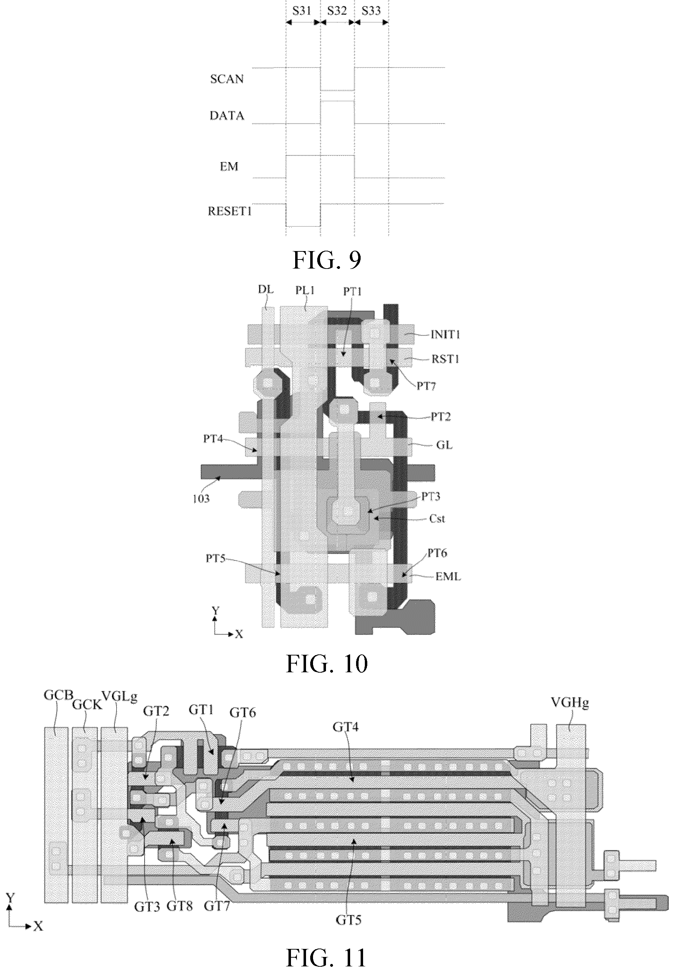

FIG. 9 is an operating timing diagram of the pixel circuit shown in FIG. 8. An operating process of the pixel circuit shown in FIG. 8 will be described below with reference to FIG. 9. Illustration is made by taking an example in which the multiple transistors included in the pixel circuit shown in FIG. 8 are P-type transistors.

In some examples, as shown in FIG. 8 and FIG. 9, during one frame of display period, an operating process of a pixel circuit may include: a reset phase S31, a data writing phase S32, and a light emitting phase S33.

In the reset phase S31, a first reset control signal RESET1 provided by the first reset control line RST1 is a low level signal, such that the first reset transistor PT1 is turned on, and a first initial voltage Vinit1 provided by the first initial voltage line INIT1 is provided to the first pixel node PN1 to initialize the first pixel node PN1 and clear an original data voltage in the pixel storage capacitor Cst. A scan signal SCAN provided by the scan line GL is a high level signal, and a light emitting control signal EM provided by the light emitting control line EML is a high level signal, so that the data writing transistor PT4, the threshold compensation transistor PT2, the first light emitting control transistor PT5, the second light emitting control transistor PT6, and the second reset transistor PT7 are turned off. In this phase, the light emitting element EL does not emit light.

In the data writing phase S32, which may also be referred to as a threshold compensation phase, a scan signal SCAN provided by the scan line GL is a low level signal, a first reset control signal RESET1 provided by the first reset control line RST1 and a light emitting control signal EM provided by the light emitting control line EML are both high level signals, and the data line DL outputs a data signal DATA. In this phase, the first electrode of the pixel storage capacitor Cst is at a low level, such that the drive transistor PT3 is turned on. The scan signal SCAN is a low level signal, so that the threshold compensation transistor PT2, the data writing transistor PT4, and the second reset transistor PT7 are turned on. The threshold compensation transistor PT2 and the data writing transistor PT4 are turned on, so that a data voltage Vdata output by the data line DL is provided to the first pixel node N1 through the second pixel node PN2, the turned-on drive transistor PT3, the third pixel node PN3, and the turned-on threshold compensation transistor PT2, and the pixel storage capacitor Cst is charged with a difference between the data voltage Vdata output by the data line DL and a threshold voltage of the drive transistor PT3. A voltage of the first electrode (that is, the first pixel node PN1) of the pixel storage capacitor Cst is Vdata-|Vth|, wherein Vdata is the data voltage output by the data line DL, and Vth is the threshold voltage of the drive transistor PT3. The second reset transistor PT7 is turned on, such that a second initial voltage Vinit2 provided by the second initial voltage line INIT2 is provided for the cathode of the light emitting element EL to initialize (reset) the anode of the light emitting element EL and clear a pre-stored voltage therein, so as to complete initialization, thereby ensuring that the light emitting element EL does not emit light. The first reset control signal RESET1 provided by the first reset control line RST1 is the high level signal, so that the first reset transistor PT1 is turned off. The light emitting control signal EM provided by the light emitting control line EML is a high level signal, and both the first light emitting control transistor PT5 and the second light emitting control transistor PT6 are turned off.

In the light emitting phase S33, the light emitting control signal EM provided by the light emitting control line EML is a low level signal, and the scan signal SCAN provided by the scan line GL and the first reset control signal RESET1 provided by the first reset control line RST1 are high level signals. The light emitting control signal EM provided by the light emitting control line EML is a low level signal, such that the first light emitting control transistor PT5 and the second light emitting control transistor PT6 are turned on, and a first voltage signal VDD output by the fifth power supply line PL1 provides a drive voltage to the anode of the light emitting element EL through the turned-on first light emitting control transistor PT5, the drive transistor PT3, and the second light emitting control transistor PT6 to drive the light emitting element EL to emit light.

In a drive process of the pixel circuit, a drive current flowing through the drive transistor PT3 is determined by a voltage difference between the control electrode and the first electrode of the drive transistor PT3. Because the voltage of the first pixel node PN1 is Vdata-|Vth|, the drive current of the drive transistor PT3 is as follows.$I = K \times {\left(Vgs-Vth\right)}^{2} = K \times {\left[\left(VDD-Vdata+\left|Vth\right|\right)-Vth\right]}^{2} = K \times {\left[VDD-Vdata\right]}^{2} ;$ wherein I is the drive current flowing through the drive transistor PT3, that is, the drive current for driving the light emitting element EL; K is a constant; Vgs is the voltage difference between the control electrode and the first electrode of the drive transistor PT3; Vth is the threshold voltage of the drive transistor PT3; Vdata is the data voltage output by the data line D; and VDD is the first voltage signal output by the fifth power supply line PL1.

It may be seen from the above formula that a current flowing through the light emitting element EL has nothing to do with the threshold voltage of the drive transistor PT3. Therefore, the pixel circuit of this embodiment can better compensate the threshold voltage of the drive transistor PT3.

FIG. 10 is a schematic partial plan view of a display region according to at least one embodiment of the present disclosure. In some examples, as shown in FIG. 10, in a direction perpendicular to the display substrate, the display substrate of the display region may at least include a base substrate, a bottom metal layer and a circuit structure layer sequentially disposed on the base substrate. The circuit structure layer of the display region may include a semiconductor layer, a first conductive layer, a second conductive layer, and a third conductive layer sequentially disposed. The semiconductor layer may at least include active layers of a plurality of transistors of the pixel circuit, for example, active layers of seven transistors of the pixel circuit may be formed into an integral structure. The first conductive layer may at least include control electrodes of a plurality of transistors of a pixel circuit, a first electrode of a pixel storage capacitor Cst, a first reset control line RST1, a scan line GL, and a light emitting control line EML. The first electrode of the pixel storage capacitor Cst and a control electrode of a drive transistor PT3 may be formed into an integral structure. A control electrode of a first anode reset transistor PT1, a control electrode of a second anode reset transistor PT7 of a pixel circuit of a previous row and the first reset control line RST1 may be formed into an integral structure. The control electrodes of a threshold compensation transistor PT2 and a data writing transistor PT4 and the scan line GL may be formed into an integral structure. Control electrodes of a first light emitting control transistor PT5 and a second light emitting control transistor PT6 and the light emitting control line EML may be formed into an integral structure. The second conductive layer may at least include a second electrode of the pixel storage capacitor and a first initial signal line INIT1. Second electrodes of the pixel storage capacitors of a plurality of pixel circuits arranged along the first direction X may be formed into an integral structure, and achieve transmitting the first voltage signal along the first direction X, and ensure the uniformity of the first voltage signal in the display region. The third conductive layer may at least include a plurality of pixel connection electrodes, a data line DL, and a fifth power supply line PL1. The data line DL and the fifth power supply line PL1 may all extend along a second direction Y.

In some examples, as shown in FIGS. 7 and 10, orthographic projections of the pixel metal blocks 103 on the base substrate may be at least partially overlapped with an orthographic projection of an active layer of at least one transistor in the pixel circuit on the base substrate. For example, the orthographic projection of the pixel metal block 103 on the base substrate may cover an orthographic projection of the channel region of the active layer of the drive transistor PT3 on the base substrate. In this example, electrostatic shielding of a pixel circuit can be achieved by disposing the pixel metal blocks 103 in the display region. However, the embodiment is not limited thereto. In some other examples, the display region may not be provided with the pixel metal blocks. For example, the first connection structure may extend to the display region, and be electrically connected with the second electrode of the pixel storage capacitor of the pixel circuit at an edge position of the display region, and electrically connected with the fifth power supply line PL1 through the second electrode of the pixel storage capacitor, so as to realize that the first metal blocks 101 receive the stable first voltage signal with a constant voltage.

Exemplary description is made below for a manufacturing process of a display substrate. A "patterning process" mentioned in the embodiments of the present disclosure includes a treatment such as photoresist coating, mask exposure, development, etching, and photoresist stripping for a metal material, an inorganic material, or a transparent conductive material, and includes a treatment such as organic material coating, mask exposure, and development for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a material on a base substrate by using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process.

"A and B have a same layer structure" or "A and B are disposed in a same layer" mentioned in the embodiments of the present disclosure means that A and B are formed simultaneously through a same patterning process, or surfaces of A and B close to a base substrate have basically a same distance from the base substrate, or surfaces of A and B close to the base substrate are in direct contact with a same film layer. A "thickness" of a film layer is a dimension of the film layer in a direction perpendicular to the display substrate. In an exemplary implementation of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A is overlapped with the boundary of the orthographic projection of B.

In some examples, the preparing process of the display substrate may include the following operations.
(1) A bottom metal layer is formed. In some examples, a bottom metal thin film is deposited on the base substrate, and the bottom metal thin film is patterned by a patterning process, to form the bottom metal layer. The bottom metal layer may include a first metal block 101 and a first connection structure 102 located in a peripheral region BB, and a pixel metal block 103 located in a display region AA, as shown in FIGS. 6A and 7.

In some examples, the base substrate 101 may be a flexible base substrate or may be a rigid base substrate. For example, the rigid base substrate may be made of a material such as glass or quartz. The flexible base substrate may be made of Polyimide (PI) or another material, and the flexible base substrate may be of a single-layer structure or a laminated structure composed of an inorganic material layer and a flexible material layer. However, the embodiment is not limited thereto.

(2) A semiconductor layer is formed. In some examples, a first insulation thin film and a first conductive thin film are sequentially deposited on the base substrate on which the aforementioned structure is formed, and the semiconductor thin film is patterned by a patterning process, to form a first insulation layer covering the bottom metal layer, and the semiconductor layer disposed on the first insulation layer, as shown in FIGS. 6B and 10.

In some examples, a material of the semiconductor layer, for example, may include poly-silicon. An active layer may include at least one channel region and a plurality of doped regions. The channel region may not be doped with an impurity, and has characteristics of a semiconductor. The plurality of doped regions may be on two sides of the channel region and be doped with impurities, and thus have conductivity. The impurities may be changed according to a type of a transistor. In some examples, a doped region of the active layer may be interpreted as a source or a drain of a transistor. A part of the active layer between the transistors may be interpreted as a wiring doped with an impurity, and may be used for electrically connecting the transistors.

(3) A first conductive layer is formed. In some examples, a second insulation thin film and a first conductive thin film are sequentially deposited on the base substrate on which the aforementioned structure is formed, and the first conductive thin film is patterned by a patterning process, to form a second insulation layer covering the semiconductor layer, and the first conductive layer disposed on the second insulation layer, as shown in FIGS. 6C and 10.

(4) A second conductive layer is formed. In some examples, a third insulation thin film and a second conductive thin film are sequentially deposited on the base substrate on which the aforementioned structures are formed, and the second conductive thin film is patterned by a patterning process, to form a third insulation layer covering the first conductive layer, and the second conductive layer disposed on the third insulation layer, as shown in FIGS. 6D and 10.

(5) A fourth insulation layer is formed. In some examples, a fourth insulation thin film is deposited on the base substrate on which the aforementioned patterns are formed,, and the fourth insulation thin film is patterned by a patterning process, to form the fourth insulation layer, as shown in FIGS. 6E and 10.

(6) A third conductive layer is formed. In some examples, a third conductive thin film is deposited on the base substrate on which the foregoing patterns are formed, the third conductive thin film is patterned by a patterning process, and the third conductive layer is formed on the fourth insulation layer, as shown in FIGS. 6F and 10.

So far, the preparation of a circuit structure layer of the display substrate is completed.

(7) A planarization layer, an anode layer, a pixel definition layer, an organic light emitting layer, and a cathode layer are sequentially formed.

In some examples, a planarization thin film is coated on the base substrate on which the aforementioned patterns are formed, and the planarization thin film is patterned by a patterning process, to form a planarization layer. The planarization layer of the display region may be provided with a plurality of pixel connection holes. Subsequently, an anode thin film is deposited on the base substrate on which the aforementioned patterns are formed, and the anode thin film is patterned through a patterning process to form an anode layer. An anode of the anode layer may be electrically connected with the corresponding pixel circuit through the pixel connection hole. Subsequently, a pixel definition thin film is coated on the base substrate on which the aforementioned patterns are formed, and a pixel definition layer is formed through mask, exposure, and development processes. The pixel define layer is formed with a plurality of pixel openings exposing the anode layer. Subsequently, an organic emitting layer is formed in the aforementioned pixel openings, and the organic emitting layer is connected with an anode. Subsequently, a cathode thin film is deposited, and the cathode thin film is patterned through a patterning process to form a cathode layer, and the cathode layer is electrically connected to the organic light emitting layer and the second power supply line, respectively. In some examples, an encapsulation layer is formed on the cathode layer. The encapsulation layer may include a stacked structure of inorganic material/organic material/inorganic material.

In some examples, the bottom metal layer, the first conductive layer, the second conductive layer, and the third conductive layer may be made of metal materials, such as any one or more of Argentum (Ag), Copper (Cu), Aluminum (Al), and Molybdenum (Mo), or an alloy material of the above metals, such as an Aluminum Neodymium alloy (AlNd) or a Molybdenum Niobium alloy (MoNb), and may be of a single-layer structure, or a multi-layer composite structure, such as Mo/Cu/Mo. The first insulation layer, the second insulation layer, the third insulation layer, and the fourth insulation layer may be made of any one or more of Silicon Oxide (SiOx), Silicon Nitride (SiNx), and Silicon Oxynitride (SiON), and may be a single layer, a multi-layer, or a composite layer. The second insulation layer and the third insulation layer may be referred to as Gate Insulation (GI) layers, and the fourth insulation layer may be referred to as Interlayer Dielectric (ILD) layer. The planarization layer may be made of an organic material, e.g., polyimide, acrylic, or polyethylene terephthalate. The pixel definition layer may be made of an organic material, such as polyimide, acrylic, or polyethylene terephthalate. The anode layer may be made of a reflective material such as a metal, and the cathode layer may be made of a transparent conductive material. However, the embodiment is not limited thereto.

A structure and a manufacturing process of the display substrate of this embodiment are merely illustrative. In some examples, a corresponding structure may be changed and a patterning process may be added or reduced according to actual needs. For example, when the display substrate is an LTPO display substrate, the circuit structure layer of the display substrate may include a first semiconductor layer, a first gate metal layer, a second gate metal layer, a second semiconductor layer, a third gate metal layer, a first source-drain metal layer, and a second source-drain metal layer. This embodiment is not limited thereto.

The manufacturing process of this exemplary embodiment may be implemented using an existing mature manufacture equipment, and is compatible well with an existing manufacturing process, simple in process implementation, easy to implement, high in a production efficiency, low in a production cost, and high in a yield.

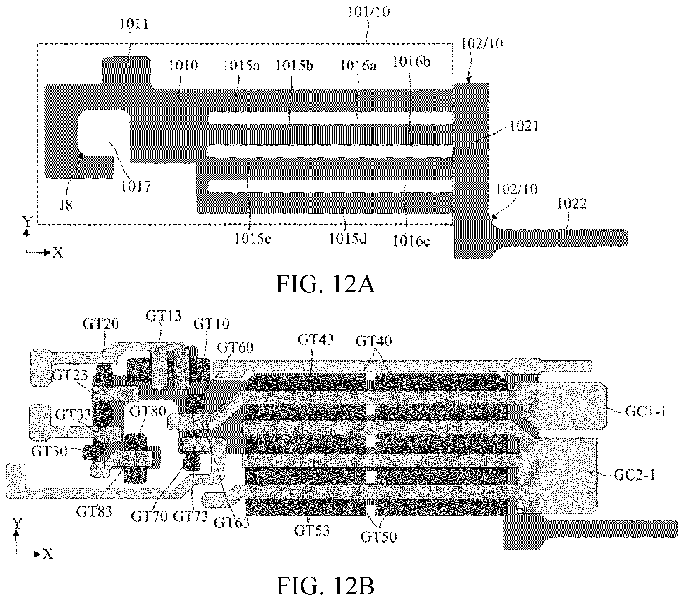

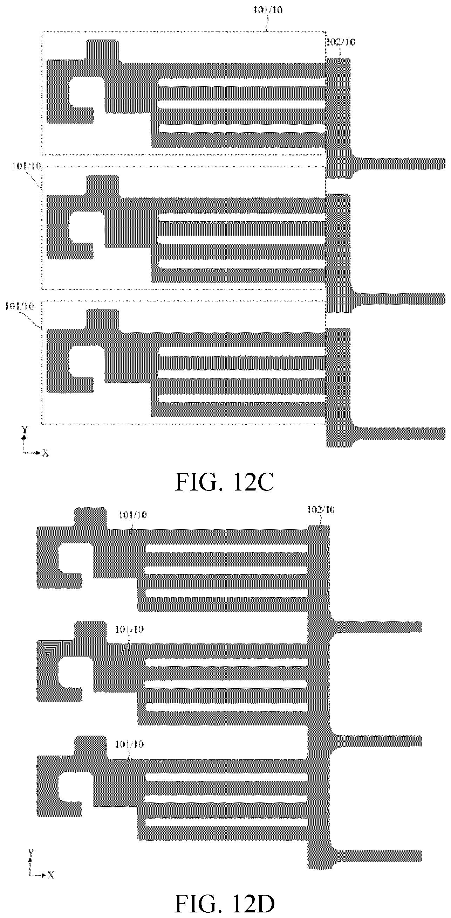

FIG. 11 is another schematic partial plan view of a peripheral region according to at least one embodiment of the present disclosure. FIG. 12A is a schematic partial plan view of a peripheral region after a bottom metal layer is formed in FIG. 11. FIG. 12B is a schematic partial plan view of a peripheral region after the first conductive layer is formed in FIG. 11. FIG. 12C is a schematic partial plan view of a bottom metal layer according to at least one embodiment of the present disclosure. FIG. 12D is another schematic partial plan view of a bottom metal layer according to at least one embodiment of the present disclosure. Three first metal blocks are illustrated in FIGS. 12C and 12D as examples.

In some examples, as shown in FIG. 12A, the bottom metal layer 10 of the peripheral region may include first metal blocks 101 and first connection structures 102. The first connection structure 102 may be located on one side of the first metal block 101 close to the display region. The first metal block 101 and the first connection structure 102 may be formed into an integral structure. One first metal block 101 may correspond to one scan drive sub-circuit.

In some examples, as shown in FIG. 12C, adjacent first metal blocks 101 may be independently disposed, and first connection structures 102 to which adjacent first metal blocks 101 are connected may be independently disposed from each other. Different first metal blocks 101 may be electrically connected with different signal lines. For example, a first first metal block and a third first metal block may be electrically connected with the first pixel power supply trace, and a second first metal block may be electrically connected with a clock signal line or peripheral power supply trace. As another example, the first first metal block may be electrically connected with the first pixel power supply traces, the second first metal block may be electrically connected with the peripheral power supply trace, and the third first metal block may be electrically connected with the clock signal line. This embodiment is not limited thereto.

In some other examples, as shown in FIG. 12D, the plurality of first metal blocks 101 may be connected by the first connection structures 102 and form into an integral structure. The plurality of first metal blocks 101 may be electrically connected with a same signal line through the first connection structures 102, for example may all be electrically connected with the first pixel power supply trace.

In some examples, as shown in FIG. 12A, a first metal block 101 may include a first main body portion 1010, a first extension portion 1011, and a plurality of fifth extension portions (e.g. four fifth extension portions 1015a, 1015b, 1015c, and 1015d). The orthographic projection of the first main body portion 1010 on the base substrate may be substantially hook-shaped. The first main body portion 1010 may have a second hollow 1017, wherein an orthographic projection of the second hollow 1017 on the base substrate may be substantially rectangular, and the first main body portion 1010 partially surrounds the second hollow 1017. For example, an edge of the second hollow 1017 may include a concave corner (e.g. corner J8) which may be of a rounded design so that the risk of static electricity generated in the process can be reduced.

In some examples, as shown in FIG. 12A, the first extension portion 1011 may extend from an upper edge of the first main body portion 1010 along a second direction Y. The four fifth extension portions 1015a, 1015b, 1015c, and 1015d may extend from the first main body portion 1010 to one side close to the display region along the first direction X and may protrude from a right edge of the first main body portion 1010. There may be a first hollow portion between adjacent fifth extension portions, for example, a first hollow portion 1016a between the fifth extension portions 1015a and 1015b, a first hollow portion 1016b between the fifth extension portions 1015b and 1015c, and a first hollow portion 1016c between the fifth extension portions 1015c and 1015d. Edges of the first hollow portions may include concave corners with a rounded design, thereby reducing the risk of static electricity generated in the process.

In some examples, as shown in FIG. 12A, a first connection structure 102 may include a first connection segment 1021 extending along the second direction Y, and a second connection segment 1022 extending along the first direction X. A connection position of the second connection segment 1022 and the first connection segment 1021 may substantially correspond to a junction position of adjacent two first metal blocks 101. Adjacent two first metal blocks 101 of this example may be connected by a first connection segment 1021, and receive an electrical signal with a constant voltage from the display region by a second connection segment 1022, for example, the second connection segment 1022 receives a first voltage signal transmitted by a first pixel power supply line by electrically connecting with a pixel metal block of the display region. However, the embodiment is not limited thereto. In some other examples, at least two adjacent first metal blocks may not be connected by the first connection segment 1021 of the first connection structure but may receive the electrical signal with a constant voltage directly by the second connection segment 1022.

In some examples, as shown in FIGS. 11 to 12B, one first metal block 101 may correspond to one scan drive sub-circuit. An orthographic projection of a single first metal block 101 on the base substrate may cover orthographic projections of channel regions of active layers of a plurality of shift transistors (i.e., a first shift transistor GT1 to an eighth shift transistor GT8) of a single scan drive sub-circuit on the base substrate. An orthographic projection of the first metal block 101 on the base substrate may be partially overlapped with orthographic projections of doped regions of the active layers of the plurality of shift transistors (e.g. including output transistors) on the base substrate. The orthographic projection of the first metal block 101 on the base substrate may be partially overlapped with an orthographic projection of a node adapter electrode on the base substrate, and may be partially overlapped with an orthographic projection of a first connection electrode on the base substrate. The orthographic projections of the node adapter electrode and the first connection electrode on the base substrate are partially overlapped with orthographic projections of second hollow portions 1017 of the first metal blocks 101 on the base substrate. The orthographic projection of the first metal block 101 on the base substrate may be not overlapped with an orthographic projection of a seventh connection electrode on the base substrate. The first metal blocks 101 of the present example may partially cover or not cover the shift nodes, and an area of a first metal block is reduced on the basis of providing an electrostatic shielding effect to reduce the risk of static electricity generated in the process.

Shapes of the first metal blocks 101 of this example are adapted to arrangements and shapes of the first shift transistor GT1 and the eighth shift transistor GT8. In this example, by using the first metal blocks 101 to provide protection below the scan drive sub-circuit, the influence of static electricity on the transistor characteristics of the scan drive sub-circuit can be shielded, so that the scan drive sub-circuit can work more stably in the case of static electricity accumulation. Furthermore, edges of the first metal blocks 101 are designed with rounded corners, so that the risk of static electricity generated in the process can be reduced. In some other examples, one first metal block may correspond to a plurality of scan drive sub-circuits.

For rest of the description of the display substrate of this embodiment, reference may be made to the description of the foregoing embodiments, so details will not be repeated here.

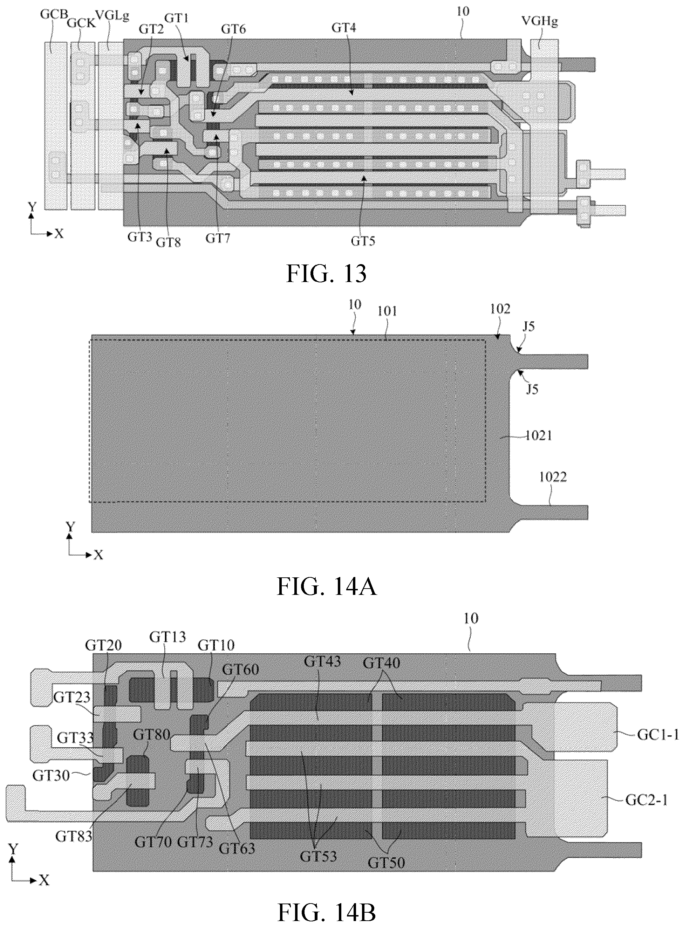

FIG. 13 is another schematic partial plan view of a peripheral region according to at least one embodiment of the present disclosure. FIG. 14A is a schematic partial plan view of a peripheral region after a bottom metal layer is formed in FIG. 13. FIG. 14B is a schematic partial plan view of a peripheral region after a first conductive layer is formed in FIG. 13.

In some examples, as shown in FIGS. 13 to 14B, the bottom metal layer 10 of the peripheral region may include first metal blocks 101 and first connection structures 102. The first metal blocks 101 of this example may be planar metal blocks, and the first metal blocks 101 are not provided with a hollow portion. The adjacent two first metal blocks 101 may be formed into an integral structure, and there is no a hollow region between the adjacent first metal blocks 101. The first connection structures 102 may be located on one side of the first metal blocks 101 adjacent to the display region. A first connection structure 102 may include a first connection segment 1021 extending along the second direction Y and a second connection segment 1022 extending along the first direction X. The first connection segment 1021 and the second connection segment 1022 may have a strip-shaped structure. A connection position of the first connection segment 1021 and the second connection segment 1022 may correspond to a junction position of two adjacent first metal blocks 101. For example, the second connection segment 1022 may extend to be electrically connected to a pixel metal block of the display region to be configured to receive a stable first voltage signal with a constant voltage. In some examples, one first metal block 101 corresponds to one scan drive sub-circuit.

In some examples, as shown in FIGS. 13 to 14B, an orthographic projection of one first metal block 101 on the base substrate may cover orthographic projections of channel regions of active layers of a plurality of shift transistors (e.g., a first shift transistor GT1 to an eighth shift transistor GT8) of a scan drive sub-circuit on the base substrate. For example, an orthographic projection of the first metal block 101 on the base substrate may cover orthographic projections of the active layers of all the shift transistors of a corresponding scan drive sub-circuit on the base substrate. The orthographic projection of the first metal block 101 on the base substrate may be partially overlapped with orthographic projections of the first shift storage capacitor and the second shift storage capacitor on the base substrate. For example, the capacitance increased by overlapping the bottom metal layer with the first shift storage capacitor and the second shift storage capacitor can be used to reduce the capacitance area of the first shift storage capacitor and the second shift storage capacitor, thereby reducing the space occupied by the first shift storage capacitor and the second shift storage capacitor, which is beneficial to reducing the space occupied by the scan drive sub-circuit. Moreover, the overlapping of the bottom metal layer with the first shift storage capacitance can increase a node capacitance of a second shift node, thereby improving the stability of the second shift node; the overlapping of the bottom metal layer with the second shift storage capacitance can increase a node capacitance of a third shift node, thereby improving the stability of the third shift node. In some other examples, the orthographic projection of the bottom metal layer on the base substrate may cover the orthographic projections of the first shift storage capacitor and the second shift storage capacitor on the base substrate. The first metal block 101 of the present example may be located below the scan drive sub-circuit to achieve large area shelter to the scan drive sub-circuit to shield static electricity and improve the antistatic capability of the scan drive sub-circuit. Furthermore, the first metal blocks 101 of this example do not need to be provided with hollows, so that the process can be simplified.

In some examples, as shown in FIG. 14A, the orthographic projection of the first metal block 101 on the base substrate may be rectangular. Adjacent first metal blocks 101 may be formed into an integral structure. The connection corner (e.g. corner J5) of the first connection segment 1021 and the second connection segment 1022 of a first connection structure 102 may be designed with rounded corner to reduce the risk of static electricity generated in the process.

For rest of the description of the display substrate of this embodiment, reference may be made to the description of the foregoing embodiments, so details will not be repeated here.

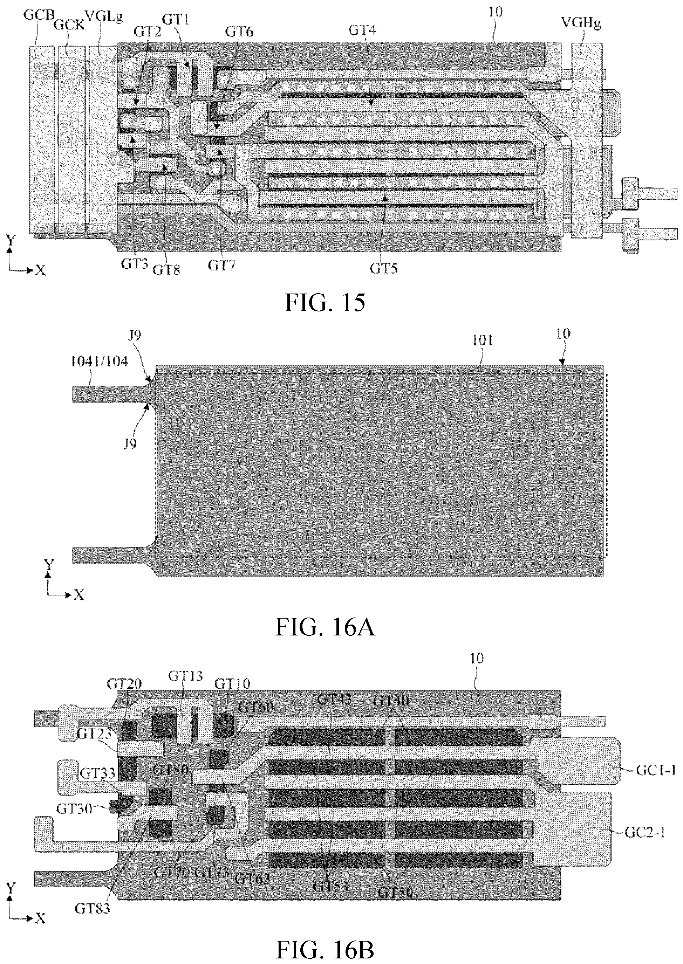

FIG. 15 is another schematic partial plan view of a peripheral region according to at least one embodiment of the present disclosure. FIG. 16A is a schematic partial plan view of a peripheral region after a bottom metal layer is formed in FIG. 15. FIG. 16B is a schematic partial plan view of a peripheral region after a first conductive layer is formed in FIG. 15.

In some examples, as shown in FIG. 16A, the bottom metal layer 10 of the peripheral region may include first metal blocks 101 and second connection structures 104. The second connection structures 104 may be located on one side of the first metal blocks 101 away from the display region. The second connection structure 104 may include a fifth connection segment 1041 extending along the first direction X. The fifth connection segment 1041 may connect two adjacent first metal blocks 101 at a junction position of the two adjacent first metal blocks 101. The fifth connection segment 1041 may be a strip-shaped structure extending from the first metal blocks 101 to a side away from the display region along the first direction X. For example, the fifth extension segment 1041 may extend below peripheral power supply lines. The peripheral power supply lines may be located in the peripheral region and on one side of a gate drive circuit away from the display region. The peripheral power supply lines may be configured to transmit an electrical signal with a constant voltage, such as a second voltage signal. In some examples, the peripheral power supply lines may be located in a third conductive layer. The fifth extension segment 1041 may be electrically connected with the peripheral power supply lines through vias opened on a fourth insulation layer to a first insulation layer, so that the first metal blocks 101 can receive the electrical signal with a constant voltage.

In some examples, as shown in FIG. 16A, the orthographic projection of the first metal block 101 on the base substrate may be rectangular. Adjacent first metal blocks 101 may be formed into an integral structure, wherein an orthographic projection of this integral structure on the base substrate may be substantially rectangular. As shown in FIGS. 15 to 16B, the orthographic projection of the first metal block 101 on the base substrate is at least partially overlapped with the orthographic projections of the active layers of a plurality of transistors of the scan drive sub-circuit on the base substrate. For example, an orthographic projection of an active layer of a third shift transistor on the base substrate is partially overlapped with the orthographic projection of the first metal block 101 on the base substrate. In some other examples, the orthographic projection of the first metal block 101 on the base substrate may cover the orthographic projections of the active layers of all shift transistors of the scan drive sub-circuit on the base substrate. However, the embodiment is not limited thereto.

In some examples, as shown in FIG. 16A, a connection corner (e.g. corner J9) of a first metal block 101 and a fifth connection segment 1041 of a second connection structure 104 may be designed with a rounded corner, thereby reducing the risk of static electricity generated in the process.

For rest of the description of the display substrate of this embodiment, reference may be made to the description of the foregoing embodiments, so details will not be repeated here.

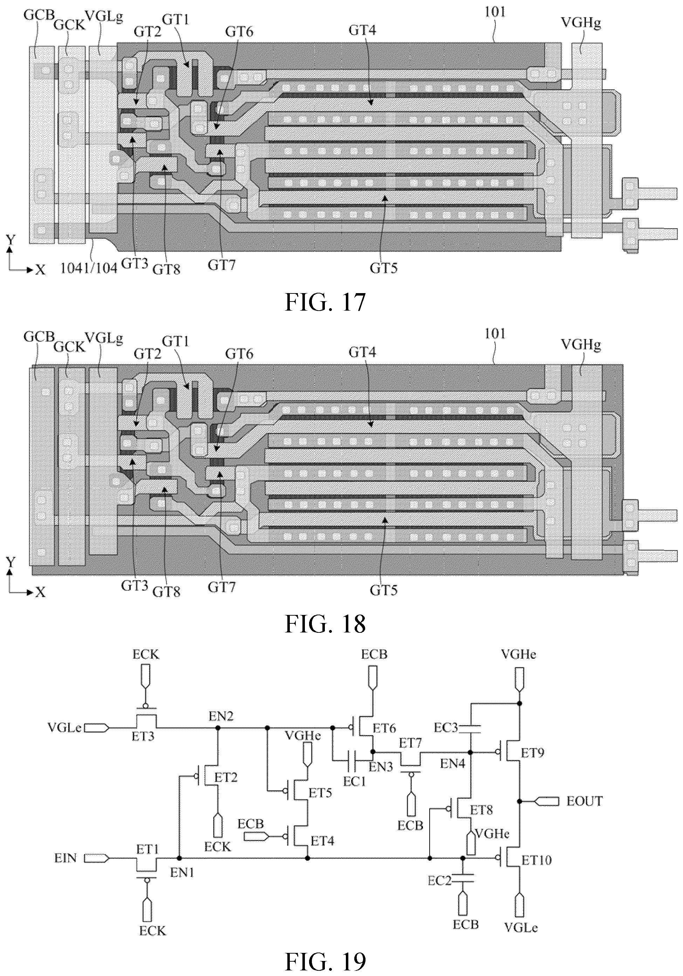

FIG. 17 is another schematic partial plan view of a peripheral region according to at least one embodiment of the present disclosure. In some examples, as shown in FIG. 17, the fifth connection segment 1041 of the second connection structure 104 of the bottom metal layer may be electrically connected with the second clock signal line GCB through vias opened on a first insulation layer to a fourth insulation layer, so that the first metal blocks 101 receive a second clock signal provided by the second clock signal line GCB, thereby realizing electrostatic shielding of the scan drive sub-circuit. The fifth connection segment 1041 is a strip-shaped structure extending along the first direction X. In this example, the second clock signal line GCB is connected through the fifth connection segment, which can reduce the influence on other traces. However, the embodiment is not limited thereto. In some other examples, the fifth connection segment 1041 of the second connection structure 104 may be electrically connected with the first clock signal line GCK; or with the second power supply line VGLg. In some other examples, the first metal blocks may be electrically connected with first power supply lines VGHg through the first connection structures. For rest of the description of the display substrate of this embodiment, reference may be made to the description of the foregoing embodiments, so details will not be repeated here.

FIG. 18 is another schematic partial plan view of a peripheral region according to at least one embodiment of the present disclosure. In some examples, as shown in FIG. 18, the first metal block 101 of the bottom metal layer may be rectangular, and the first metal block 101 may extend below the second clock signal line GCB and be electrically connected directly with the second clock signal line GCB through vias opened on the first insulation layer to the fourth insulation layer. In some examples, the orthographic projection of the first metal block 101 on the base substrate may cover the orthographic projections of the first shift storage capacitor and the second shift storage capacitor on the base substrate. The capacitance generated by overlapping of the first metal block 101 with the first shift storage capacitor can be used to reduce the capacitance area of the first shift storage capacitor, thereby reducing the space occupied by the first shift storage capacitor, which is beneficial to reducing the space occupied by the scan drive sub-circuit. The capacitance generated by overlapping of the first metal block 101 with the second shift storage capacitor can be used to reduce the capacitance area of the second shift storage capacitor, thereby reducing the space occupied by the second shift storage capacitor, which is beneficial to reducing the space by the scan drive sub-circuit. Moreover, the overlapping of the first metal block 101 with the first shift storage capacitance can increase a node capacitance of a second shift node, thereby improving the stability of the second shift node; and the overlapping of the first metal block 101 with the second shift storage capacitance may increase a node capacitance of a third shift node, thereby improving the stability of the third shift node. For rest of the description of the display substrate of this embodiment, reference may be made to the description of the foregoing embodiments, so details will not be repeated here.

In some examples, the gate drive circuit of the peripheral region may include a scan drive circuit and a light emitting drive circuit. The light emitting drive circuit may be located on one side of the scan drive circuit away from the display region. The light emitting drive circuit may be configured to generate a light emitting control signal provided to a light emitting control line of the display region. The light emitting drive circuit may include a plurality of cascaded drive control sub-circuits. An input terminal of a light emitting drive circuit of a first stage may be electrically connected with a light emitting starting signal line ESTV, and an output terminal of a light emitting drive sub-circuit of an i-th stage may be electrically connected with an input terminal of a light emitting drive sub-circuit of an (i+1)-th stage, where i is a positive integer. In some examples, a plurality of cascaded second circuit units included in the gate drive circuit may be a plurality of cascaded light emitting drive sub-circuits. In the following, illustration is made by taking an example in which a second circuit unit is a light emitting drive sub-circuit.

FIG. 19 is an equivalent circuit diagram of a light emitting drive sub-circuit according to at least one embodiment of the present disclosure. In some examples, as shown in FIG. 19, the light emitting drive sub-circuit of this example may include: a first control transistor ET1 to a tenth control transistor ET10, a first control storage capacitor EC1, a second control storage capacitor EC2, and a third control storage capacitor EC3. A ninth control transistor ET9 and a tenth control transistor ET10 are output transistors of the light emitting drive sub-circuit. The first control transistor ET1 is an input transistor of the light emitting drive sub-circuit.

In this exemplary embodiment, as shown in FIG. 19, a control electrode of the first control transistor ET1 is electrically connected with a third clock signal line ECK, a first electrode of the first control transistor ET1 is electrically connected with a control input terminal EIN, and a second electrode of the first control transistor ET1 is electrically connected with a first control node EN1. A control electrode of a second control transistor ET2 is electrically connected with the first control node EN1, a first electrode of the second control transistor ET2 is electrically connected with the third clock signal line ECK, and a second electrode of the second control transistor ET2 is electrically connected with a second control node EN2. A control electrode of a third control transistor ET3 is electrically connected with the third clock signal line ECK, a first electrode of the third control transistor ET3 is electrically connected with a fourth power supply line VGLe, and a second electrode of the third control transistor ET3 is electrically connected with the second control node EN2. A control electrode of a fourth control transistor ET4 is electrically connected with a fourth clock signal line ECB, a first electrode of the fourth control transistor ET4 is electrically connected with a second electrode of a fifth control transistor ET5, and a second electrode of the fourth control transistor ET4 is electrically connected with the first control node EN1. A control electrode of the fifth transistor ET5 is electrically connected with the second control node EN2, and a first electrode of the fifth control transistor ET5 is electrically connected with a third power supply line VGHe. A control electrode of a sixth control transistor ET6 is electrically connected with the second control node EN2, a first electrode of the sixth control transistor ET6 is electrically connected with the fourth clock signal line ECB, and a second electrode of the sixth control transistor ET6 is electrically connected with a third control node EN3. A control electrode of the seventh control transistor ET7 is electrically connected with the fourth clock signal line ECB, a first electrode of the seventh control transistor ET7 is electrically connected with the third control node EN3, and a second electrode of the seventh control transistor ET7 is electrically connected with a fourth control node EN4. A control electrode of an eighth control transistor ET8 is electrically connected with the first control node EN1, a first electrode of the eighth control transistor ET8 is electrically connected with the third power supply line VGHe, and a second electrode of the eighth control transistor ET8 is electrically connected with the fourth control node EN4. A control electrode of a ninth control transistor ET9 is electrically connected with the fourth control node EN4, a first electrode of the ninth control transistor ET9 is electrically connected with the third power supply line VGHe, and a second electrode of the ninth control transistor ET9 is electrically connected with a control output terminal EOUT. A control electrode of a tenth control transistor ET10 is electrically connected with the first control node EN1, a first electrode of the tenth control transistor ET10 is electrically connected with a fourth power supply line VGLe, and a second electrode of the tenth control transistor ET10 is electrically connected with the control output terminal EOUT. A first electrode of the first control storage capacitor EC1 is electrically connected to the control electrode of the sixth control transistor ET6, and a second electrode of the first control storage capacitor EC1 is electrically connected to the third control node EN3. A first electrode of a second control storage capacitor EC2 is electrically connected with the control electrode of the tenth control transistor ET10, and a second electrode of the second control storage capacitor EC2 is electrically connected with the fourth clock signal line ECB. A first electrode of the third control storage capacitor EC3 is electrically connected with the control electrode of the ninth control transistor ET9, and a second electrode of the third control storage capacitor EC3 is electrically connected with the third power supply line VGHe.

In the present exemplary embodiment, as shown in FIG. 19, the first control node EN1 is a connection point of the first control transistor ET1, the second control transistor ET2, the fourth control transistor ET4, the eighth control transistor ET8, the tenth control transistor ET10 and the second control storage capacitor EC2. The second control node EN2 is a connection point of the third control transistor ET3, the second control transistor ET2, the fifth control transistor ET5, the sixth control transistor ET6 and the first control storage capacitor EC1. The third control node EN3 is a connection point of the sixth control transistor ET6, the seventh control transistor ET7 and the first control storage capacitor EC1. The fourth control node EN4 is a connection point of the seventh control transistor ET7, the eighth control transistor ET8, the ninth control transistor ET9 and the third control storage capacitor EC3.

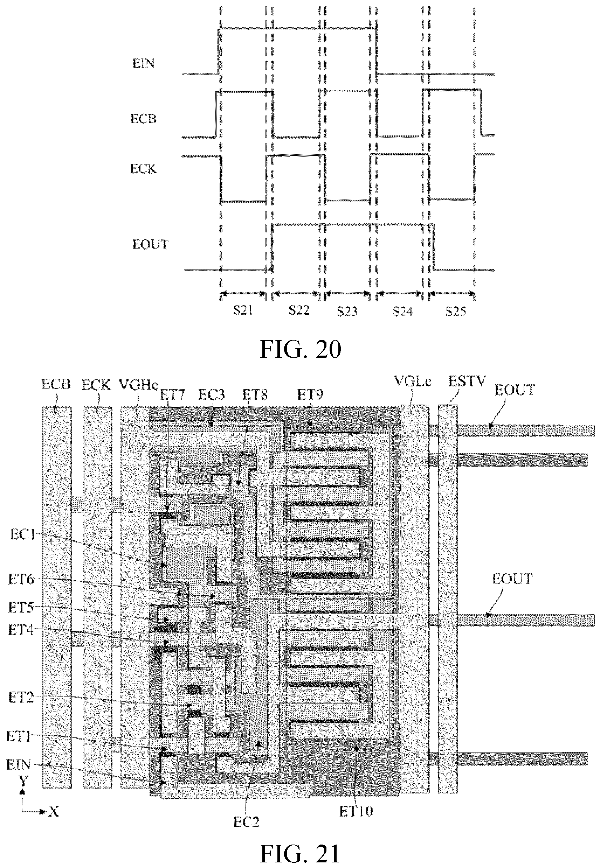

The following illustration is made with an example that the first control transistor ET1 to the tenth control transistor ET10 are all P-type transistors. The light emitting drive sub-circuit in the first stage is taken as an example for illustration. The control input terminal EIN of the light emitting drive sub-circuit in the first stage is electrically connected with a light emitting start signal line ESTV. FIG. 20 is an operating timing diagram of the light emitting drive sub-circuit shown in FIG. 19. As shown in FIGS. 19 and 20, the light emitting drive sub-circuit of this exemplary embodiment includes ten transistor units (i.e., the first control transistor ET1 to the tenth control transistor ET10), three capacitor units (i.e., the first control storage capacitor EC1 to the third control storage capacitor EC3), three input terminals (i.e., the third clock signal line ECK, the fourth clock signal line ECB, the control input terminal EIN), one output terminal (i.e., the control output terminal EOUT), and two power supply terminals (i.e., the third power supply line VGHe and the fourth power supply line VGLe). The third power supply line VGHe may continuously provide a high level signal, and the fourth power supply line VGLe may continuously provide a low level signal.

In some examples, as shown in FIGS. 19 and 20, a working process of the light emitting drive sub-circuit of this example includes the following phases.

In a first phase S21, a third clock signal provided by the third clock signal line ECK is a low level, so the first control transistor ET1 and the third control transistor ET3 are turned on, and the turned-on first control transistor ET1 transmits a high level signal of the control input terminal EIN to the first control node EN1, such that a level of the first control node EN1 turns into a high level, so that the second control transistor ET2, the eighth control transistor ET8 and the tenth control transistor ET10 are turned off. In addition, the turned-on third control transistor ET3 transmits a low level signal of the fourth power supply line VGLe a to the second control node EN2, such that a level of the second control node EN2 turns into a low level, so that the fifth control transistor ET5 and the sixth control transistor ET6 are turned on. Since the fourth clock signal provided by the fourth clock signal line ECB is a high level, the seventh control transistor ET7 and the fourth control transistor ET4 are turned off. In addition, the ninth control transistor ET9 is turned off due to a storage effect of the third control storage capacitor EC3. In the first phase S21, since both the ninth control transistor ET9 and the tenth control transistor ET10 are turned off, a signal of the control output line EOUT is kept at a previous low level.

In a second phase S22, the fourth clock signal provided by the fourth clock signal line ECB is at a low level, so the fourth control transistor ET4 and the seventh control transistor ET7 are turned on. Since the signal of the third clock signal line ECK is at the high level, the first control transistor ET1 and the third control transistor ET3 are turned off. Due to the storage effect of the first control storage capacitor EC1, the second control node EN2 may maintain the low level of the previous phase, so the fifth control transistor ET5 and the sixth control transistor ET6 are turned on. A high level signal of the third power supply line VGHe is transmitted to the first control node EN1 through the fifth control transistor ET5 and the fourth control transistor ET4 which are turned on, such that a level of the first control node EN1 continues maintaining the high level of the previous phase, so the second control transistor ET2, the eighth control transistor ET8 and the tenth control transistor ET10 are turned off. In addition, the low level signal of the fourth clock signal line ECB is transmitted to the control electrode of the ninth control transistor ET9 through the sixth control transistor ET6 and the seventh control transistor ET7 which are turned on, the ninth control transistor ET9 is turned on, and the turned-on ninth control transistor ET9 outputs the high level signal of the third power supply line VGHe, so the signal of the control output terminal EOUT is at a high level.

In a third phase S23, the third clock signal of the third clock signal line ECK is at the low level, so the first control transistor ET1 and the third control transistor ET3 are turned on. Since the signal of the fourth clock signal line ECB is at a high level, the fourth control transistor ET4 and the seventh control transistor ET7 are turned off. Due to a storage effect of the third control storage capacitor EC3, the ninth control transistor ET9 maintains a turned-on state, and the turned-on ninth control transistor ET9 outputs the high level signal of the third power supply line VGHe, and the signal of the control output terminal EOUT is still at the high level.

In a fourth phase S24, the third clock signal of the third clock signal line ECK is at a high level, so the first control transistor ET1 and the third control transistor ET3 are turned off. The signal of the fourth clock signal line ECB is at a low level, so the fourth control transistor ET4 and the seventh control transistor ET7 are turned on. Due to a storage effect of the second control storage capacitor EC2, the level of the first control node EN1 maintains the high level of the previous phase, such that the second control transistor ET2, the eighth control transistor ET8 and the tenth control transistor ET10 are turned off. Due to a storage effect of the first control storage capacitor EC1, the second control node EN2 continues maintaining the low level of the previous phase, such that the fifth control transistor ET5 and the sixth control transistor ET6 are turned on. In addition, the low level signal of the fourth clock signal line ECB is transmitted to the control electrode of the ninth control transistor ET9 through the sixth control transistor ET6 and the seventh control transistor ET7 which are turned on, so the ninth control transistor ET9 is turned on and the turned-on ninth control transistor ET9 outputs the high level signal of the third power supply line VGHe, so the signal of the control output terminal EOUT is still at a high level.

In a fifth phase S25, the signal of the third clock signal line ECK is at a low level, so the first control transistor ET1 and the third control transistor ET3 are turned on. Since the signal of the fourth clock signal line ECB is at a high level, the fourth control transistor ET4 and the seventh control transistor ET7 are turned off. The turned-on first control transistor ET1 transmits a low level signal of the control input terminal EMIN to the first control node EN1, such that the level of the first control node EN1 turns into the low level, then the second control transistor ET2, the eighth control transistor ET8, and the tenth control transistor ET10 are turned on. The turned-on second control transistor ET2 transmits the low level signal of the third clock signal line ECK to the second control node EN2, such that the level of the second control node EN2 may be further lowered and the second control node EN2 continues maintaining the low level of the previous phase, and thus the fifth control transistor ET5 and the sixth control transistor ET6 are turned on. In addition, the turned-on eighth control transistor ET8 transmits the high level signal of the third power supply line VGHe to the control electrode of the ninth control transistor ET9, so the ninth control transistor ET9 is turned off. The turned-on tenth control transistor ET10 outputs the low level signal of the fourth power supply line VGLe, and then the signal of the control output terminal EOUT turns into a low level.

The control output terminal EOUT of the light emitting drive sub-circuit provided in this example can provide a light emitting control signal for a pixel circuit of the display region through the light emitting control line.

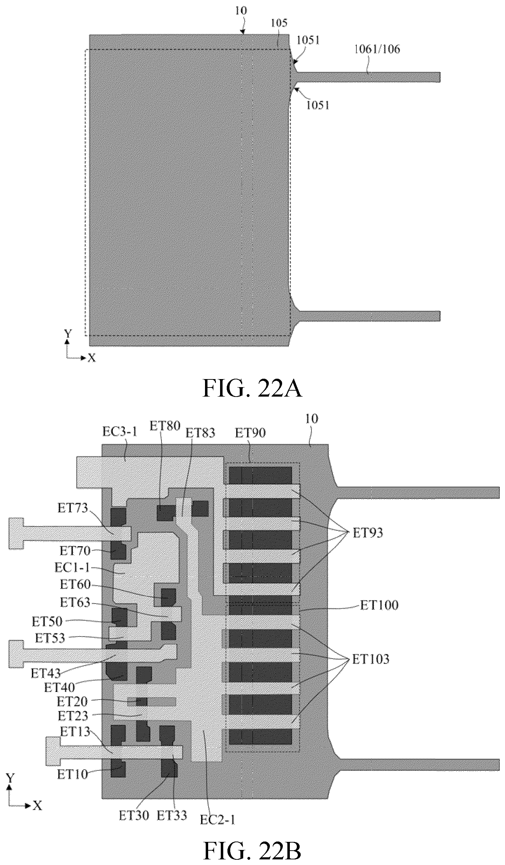

FIG. 21 is a schematic partial plan view of a peripheral region according to at least one embodiment of the present disclosure. FIG. 22A is a schematic partial plan view of a peripheral region after a bottom metal layer is formed in FIG. 21. FIG. 22B is a schematic partial plan view of a peripheral region after a first conductive layer is formed in FIG. 21.

In some examples, as shown in FIG. 21, in a direction parallel to the display substrate, the third power supply line VGHe, the third clock signal line ECK, and the fourth clock signal line ECB are located on one side of the light emitting drive sub-circuit away from the display region along the first direction X, and are sequentially arranged along a direction away from the display region. The fourth power supply line VGLe and the light emitting start signal line ESTV are located on one side of the light emitting drive sub-circuit close to the display region along the first direction X. A scan drive circuit may be provided on one side of the fourth power supply line VGLe and the light emitting start signal line ESTV close to the display region. The third power supply line VGHe, the third clock signal line ECK, the fourth clock signal line ECB, the fourth power supply line VGLe, and the light emitting start signal line ESTV all extend along the second direction Y.

In some examples, as shown in FIG. 21, the light emitting drive sub-circuit is located between the fourth power supply line VGLe and the third power supply line VGHe. The seventh control transistor ET7, the fifth control transistor ET5, the fourth control transistor ET4, and the first control transistor ET1 are sequentially arranged along the second direction Y and are located on one side of the third power supply line VGHe close to the display region. The eighth control transistor ET8 may be located between the seventh control transistor ET7 and the ninth control transistor ET9 in the first direction X. The sixth control transistor ET6 may be located on one side of the fifth control transistor ET5 away from the third power supply line VGHe. The first control transistor ET1, the second control transistor ET1 , and the third control transistor ET3 may be sequentially arranged along the first direction X, and are located between the third power supply line VGLe and the second control storage capacitor EC2. The tenth control transistor ET10 may be located between the second control storage capacitor EC2 and the fourth power supply line VGLe. The ninth control transistor ET9 and the tenth control transistor ET10 are sequentially arranged along the second direction Y. The third control storage capacitor EC3, the first control storage capacitor EC1, and the second control storage capacitor EC2 may be sequentially arranged in the second direction Y. The third control storage capacitor EC3 may be located on one side of the seventh control transistor ET7 and the eighth control transistor ET8 away from the first control storage capacitor EC1. The first control storage capacitor EC1 may be located between the seventh control transistor ET7 and the sixth control transistor ET6. The first control transistor ET1 may be located on one side of the tenth control transistor ET10 away from the display region.

In some examples, as shown in FIG. 21 to FIG. 22B, the semiconductor layer of the peripheral region may at least include: active layers of a plurality of transistors of a light emitting drive sub-circuit (e.g., an active layer ET10 of the first control transistor, an active layer ET20 of the second control transistor, an active layer ET30 of the third control transistor, an active layer ET40 of the fourth control transistor, an active layer ET50 of the fifth control transistor, an active layer ET60 of the sixth control transistor, an active layer ET70 of the seventh control transistor, an active layer ET80 of the eighth control transistor, an active layer ET90 of the ninth control transistor, and an active layer ET100 of the tenth control transistor). In some examples, the active layer ET40 of the fourth control transistor and the active layer ET50 of the fifth control transistor may be formed into an integral structure. The active layer ET90 of the ninth control transistor and the active layer ET100 of the tenth control transistor may be formed into an integral structure.

In some examples, as shown in FIG. 22B, the first conductive layer of the peripheral region may at least include: control electrodes of a plurality of transistors of a light emitting drive sub-circuit (e.g., including: a control electrode ET13 of the first control transistor, a control electrode ET23 of the second control transistor, a control electrode ET33 of the third control transistor, a control electrode ET43 of the fourth control transistor, a control electrode ET53 of the fifth control transistor, a control electrode ET63 of the sixth control transistor, a control electrode ET73 of the seventh control transistor, a control electrode ET83 of the eighth control transistor, a control electrode ET93 of the ninth control transistor, and a control electrode ET103 of the tenth control transistor), a first electrode EC1-1 of a first control storage capacitor, a first electrode EC2-1 of a second control storage capacitor, a first electrode EC3-1 of a third control storage capacitor of a light emitting drive sub-circuit.

In some examples, as shown in FIG. 22B, the control electrode ET53 of the fifth control transistor, the control electrode ET63 of the sixth control transistor, and the first electrode EC1-1 of the first control storage capacitor may be formed into an integral structure. The control electrode ET23 of the second control transistor, the control electrode ET83 of the eighth control transistor, the control electrode ET103 of the tenth control transistor, and the first electrode EC2-1 of the second control storage capacitor may be formed into an integral structure. The control electrode ET13 of the first control transistor and the control electrode ET33 of the third control transistor may be formed into an integral structure. The control electrode ET93 of the ninth control transistor and the first electrode EC3-1 of the third control storage capacitor may be formed into an integral structure.

In some examples, as shown in FIG. 21, the second conductive layer of the peripheral region may at least include: a second electrode of the first control storage capacitor EC1, a second electrode of the second control storage capacitor EC2, a second electrode of the third control storage capacitor EC3, and the control output terminal EOUT, of the light emitting drive sub-circuit. An orthographic projection of the second electrode of the first control storage capacitor EC1 on the base substrate is within an orthographic projection range of the first electrode EC1-1 on the base substrate. An orthographic projection of the second electrode of the second control storage capacitor EC2 on the base substrate is within an orthographic projection range of the first electrode EC2-1 on the base substrate. An orthographic projection of the second electrode of the third control storage capacitor EC3 on the base substrate is within an orthographic projection range of the first electrode EC3-1 on the base substrate. The control output terminal EOUT is located on one side of the active layer ET90 of the ninth control transistor and the active layer ET100 of the tenth control transistor close to the display region. An orthographic projection of the control output terminal EOUT on the base substrate may be F-shaped. The control output terminal EOUT may extend to be electrically connected with the first output connection line 35 in the aforementioned embodiments to be configured to provide a light emitting control signal to the pixel circuit of the display region.

In some examples, as shown in FIG. 21, the third conductive layer of the peripheral region may at least include a plurality of connection electrodes of the light emitting drive sub-circuit, a third clock signal line ECK, a fourth clock signal line ECB, a third power supply line VGHe, a fourth power supply line VGLe, and a control input terminal EIN.

In some examples, as shown in FIG. 22A, the bottom metal layer 10 of the peripheral region may include second metal blocks 105 and third connection structures 106. The third connection structures 106 may be located on one side of the second metal blocks 105 close to the display region. A third connection structure 106 may include a sixth connection segment 1061 extending along the first direction X. The sixth connection segment 106 may be a strip-shaped structure extending along the first direction X toward a side close to the display region. For example, the sixth connection segment 1061 may be electrically connected with the fifth connection segment of the second connection structure in the aforementioned embodiments. For example, one sixth connection segment and one fifth connection segment may be formed into an integral structure. Electrical connection between a first metal block and a second metal block can be achieved by electrically connecting the sixth connection segment with the fifth connection segment. The second metal blocks 105 may be configured to receive an electrical signal with a constant voltage through the first metal blocks. However, the embodiment is not limited thereto. In some other examples, the bottom metal layer 10 may be a planar metal structure, i.e. the third connection structure and the second connection structure may be formed into an integral planar metal block rather than a strip structure.

In some examples, one second metal block 105 may correspond to one light emitting drive sub-circuit. Adjacent second metal blocks 105 may be formed into an integral structure. However, the embodiment is not limited thereto. In some other examples, one second metal block 105 may correspond to a plurality of light emitting drive sub-circuits. **In** some other examples, at least two adjacent second metal blocks may be disposed separately without connection.

In some examples, as shown in FIG. 22A, an orthographic projection of a second metal block 105 on the base substrate may cover orthographic projections of the channel regions of the active layers of a plurality of control transistors of a light emitting drive sub-circuit on the base substrate. For example, the orthographic projection of the second metal block 105 on the base substrate may cover orthographic projections of the active layers of all control transistors (e.g., including the first control transistor ET1 to the tenth control transistor ET10) of the corresponding light emitting drive sub-circuit on the base substrate. The orthographic projection of the second metal block 105 on the base substrate may cover orthographic projections of a plurality of control nodes of the light emitting drive sub-circuit on the base substrate, thereby shielding influence of the static electricity on the plurality of control nodes with the second metal blocks 105. The orthographic projection of the second metal block 105 on the base substrate may be at least partially overlapped with orthographic projections of the three control storage capacitors of the light emitting drive sub-circuit on the base substrate, thereby facilitating the improvement of the stability of the corresponding control nodes, and the area of the control storage capacitors can be reduced by using the capacitances generated by overlapping of the second metal block with the control storage capacitors, thereby facilitating the reduction of the space occupied by the control storage capacitors. The second metal block 105 of the present example may be located below the light emitting drive sub-circuit to realize large-area shelter to the light emitting drive sub-circuit, to shield static electricity and improve the antistatic capability of the light emitting drive sub-circuit.

In some examples, as shown in FIG. 22A, the orthographic projection of the second metal block 105 on the base substrate may be rectangular. Adjacent second metal blocks 105 may be formed into an integral structure. The connection corner (e.g. Corner 1051) of the second metal block 105 and the sixth extension segment 1061 of the third connection structure 106 may be designed with the rounded corner, thereby reducing the risk of static electricity generated in the process.

In some examples, the bottom metal layer of the peripheral region can shelter the scan drive sub-circuit and the light emitting drive sub-circuit in a large area, i.e., cover at least orthographic projections of channel regions of the active layers of all transistors of the scan drive sub-circuit and the light emitting drive sub-circuit on the base substrate, thereby protecting the scan drive sub-circuit and the light emitting drive sub-circuit, enabling the gate drive circuit to work stably under the condition of static electricity accumulation, and improving the antistatic capability of the gate drive circuit.

For rest of the description of the display substrate of this embodiment, reference may be made to the description of the foregoing embodiments, so details will not be repeated here.

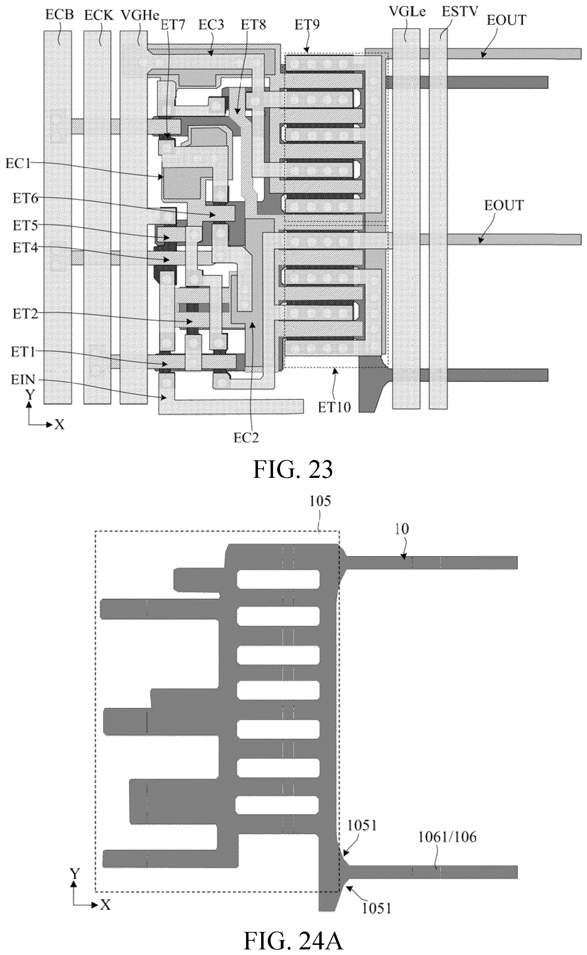

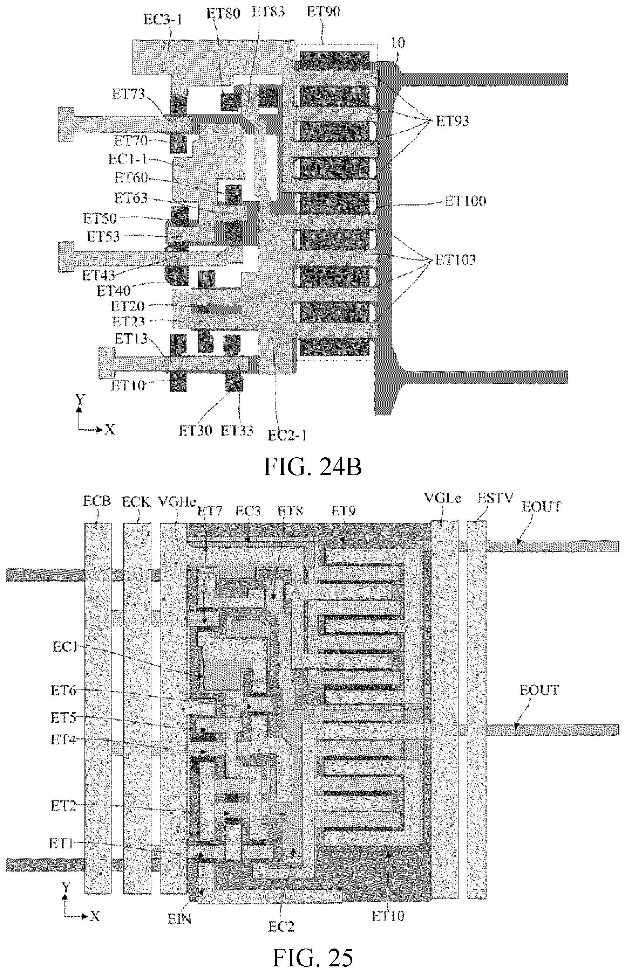

FIG. 23 is a schematic partial plan view of a peripheral region according to at least one embodiment of the present disclosure. FIG. 24A is a schematic partial plan view of a peripheral region after a bottom metal layer is formed in FIG. 23. FIG. 24B is a schematic partial plan view of a peripheral region after a first conductive layer is formed in FIG. 23.

In some examples, as shown in FIG. 23 to FIG. 24B, the bottom metal layer 10 of the peripheral region may include second metal blocks 105 and third connection structures 106. An orthographic projection of the second metal block 105 on the base substrate may cover orthographic projections of channel regions of active layers of a plurality of control transistors (e.g. a first control transistor ET1 to a tenth control transistor ET10) of a light emitting drive sub-circuit on the base substrate. For example, the orthographic projection of the second metal block 105 on the base substrate may be partially overlapped with orthographic projections of doped regions of active layers of a plurality of control transistors (e.g. output transistors) of the corresponding light emitting drive sub-circuit on the base substrate. Shapes of the second metal block 105 of this example may correspond to shapes and arrangements of the control transistors of the light emitting drive sub-circuit. The second metal block of the bottom metal layer of the present example can shelter the channel regions of the active layers of the transistors of the light emitting drive sub-circuit to shield static electricity, thereby protecting the light emitting drive sub-circuit, enabling the gate drive circuit to work stably under the condition of static electricity accumulation, and improving the antistatic capability of the gate drive circuit. For rest of the description of the display substrate of this embodiment, reference may be made to the description of the foregoing embodiments, so details will not be repeated here.

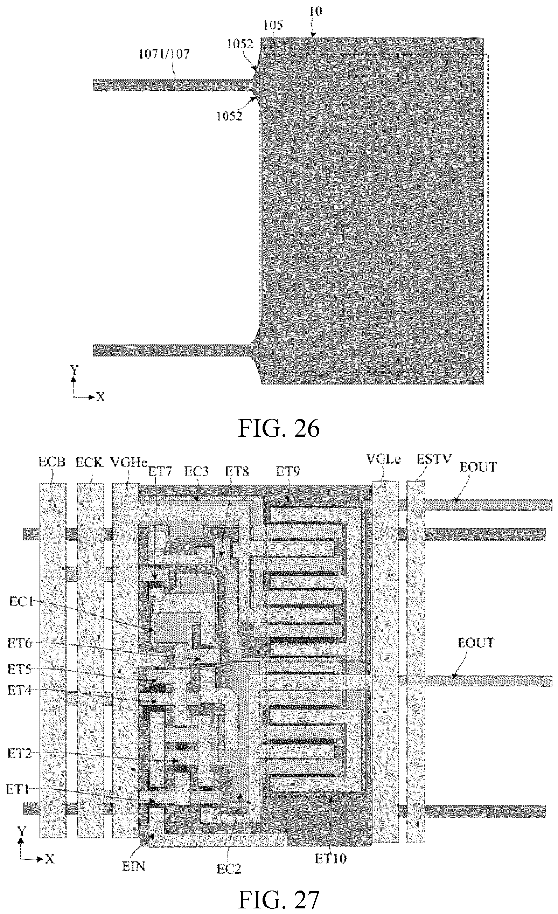

FIG. 25 is a schematic partial plan view of a peripheral region according to at least one embodiment of the present disclosure. FIG. 26 is a schematic partial plan view of a peripheral region after a bottom metal layer is formed in FIG. 25.

In some examples, as shown in FIGS. 25 and 26, the bottom metal layer 10 of the peripheral region may include second metal blocks 105 and fourth connection structures 107. The fourth connection structures 107 may be located on one side of the second metal blocks 105 away from the display region. A fourth connection structure 107 may include a seventh connection segment 1071 extending along the first direction X. The seventh connection segment 1071 may be a strip structure extending along the first direction X to a side away from the display region. The seventh connection segment 1071 may extend below the peripheral power supply lines and be electrically connected with the peripheral power supply lines through a via opened in the insulation layer, thereby enabling the second metal blocks 105 to receive an electrical signal with a constant voltage, such as a second voltage signal.

In this example, the bottom metal layer 10 may be configured to be electrically connected with two electrical signals with a constant voltage. The plurality of second metal blocks 105 may be formed into an integral structure and electrically connected with the peripheral power supply lines through the fourth connection structures 107 to receive a stable second voltage signal with a constant voltage; a plurality of first metal blocks may be formed into an integral structure, and may be electrically connected with the pixel metal blocks of the display region through the first connection structures, so as to be electrically connected with the first pixel power supply lines through the pixel metal blocks, and receive a stable first voltage signal with a constant voltage.

In some examples, as shown in FIGS. 25 and 26, an orthographic projection of a second metal block 105 on the base substrate may cover orthographic projections of channel regions of active layers of a plurality of control transistors of a light emitting drive sub-circuit on the base substrate. For example, the orthographic projection of the second metal block 105 on the base substrate may cover the orthographic projections of the active layers of the control transistors of the corresponding light emitting drive sub-circuit on the base substrate. For example, the orthographic projection of the second metal block 105 on the base substrate may be rectangular. Adjacent second metal blocks 105 may be formed into an integral structure. A connection corner (e.g. corner 1052) of a second metal block 105 and a seventh connection segment 1071 of a fourth connection structure 107 may be designed with a rounded corner to reduce the risk of static electricity generated in the process. Rest of the structure of the display substrate according to this embodiment may be referred to descriptions of the aforementioned embodiments, and will not be repeated here.

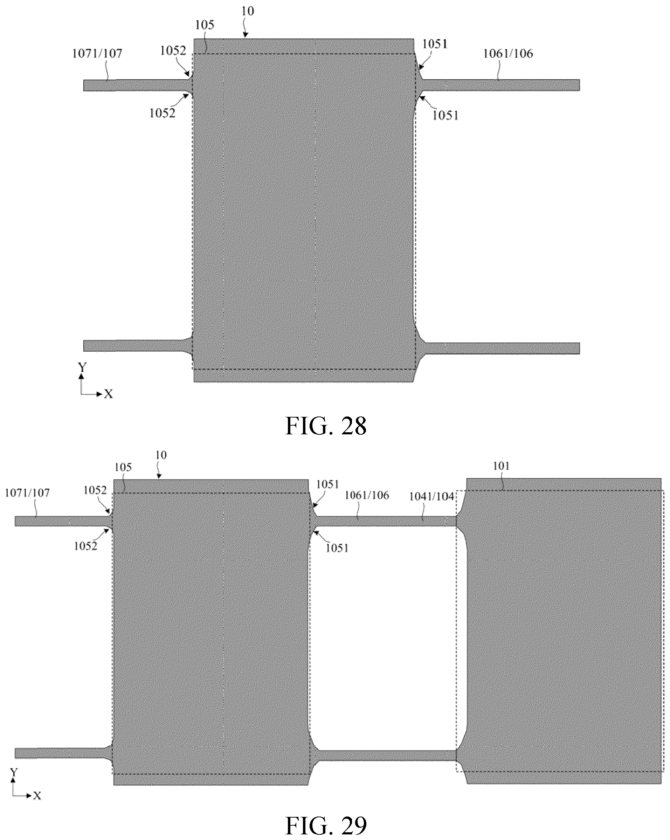

FIG. 27 is a schematic partial plan view of a peripheral region according to at least one embodiment of the present disclosure. FIG. 28 is a schematic partial plan view of a peripheral region after a bottom metal layer is formed in FIG. 27. FIG. 29 is a schematic partial view of a bottom metal layer of a peripheral region according to at least one embodiment of the present disclosure.

In some examples, as shown in FIGS. 27 to 29, the bottom metal layer 10 of the peripheral region may include a second metal block 105, a third connection structure 106, and a fourth connection structure 107. The third connection structure 106 may be located on one side of the second metal block 105 close to the display region. The third connection structure 106 may include a sixth connection segment 1061 extending along the first direction X. The sixth connection segment 1061 may be a strip structure extending along the first direction X toward a side close to the display region. The sixth connection segment 1061 may be electrically connected with a fifth connection segment 1041 of the second connection structure 104, for example, may be formed into an integral structure. An electrical connection between the first metal block 101 and the second metal block 105 can be achieved by electrically connecting the sixth connection segment 1061 with the fifth connection segment 1041. The fourth connection structure 107 may be located on one side of the second metal block 105 away from the display region. The fourth connection structure 107 may include a seventh connection segment 1071 extending along the first direction X. The seventh connection segment 1071 may be a strip structure extending along the first direction X to a side away from the display region. The seventh connection segment 1071 may extend below the peripheral power supply lines and be electrically connected with the peripheral power supply lines through vias opened in the insulation layer, thereby enabling the second metal block 105 to receive an electrical signal with a constant voltage, such as a second voltage signal. In some examples, the second metal block 105 and the first metal block 101 of the bottom metal layer 10 may be formed into an integral structure, and may be configured to be electrically connected with a same electrical signal with a constant voltage (e.g. a second voltage signal). In some other examples, a seventh connection segment 1071 of the fourth connection structure 107 may be electrically connected with a clock signal line (e.g. a fourth clock signal line ECB or a third clock signal line ECK) to be configured to receive a clock signal. In some other examples, a sixth connection segment 1061 of the third connection structure 106 may be electrically connected with a clock signal line (e.g. a first clock signal line or a second clock signal line). Rest of the structure of the display substrate according to this embodiment may be referred to descriptions of the aforementioned embodiments, and will not be repeated here.

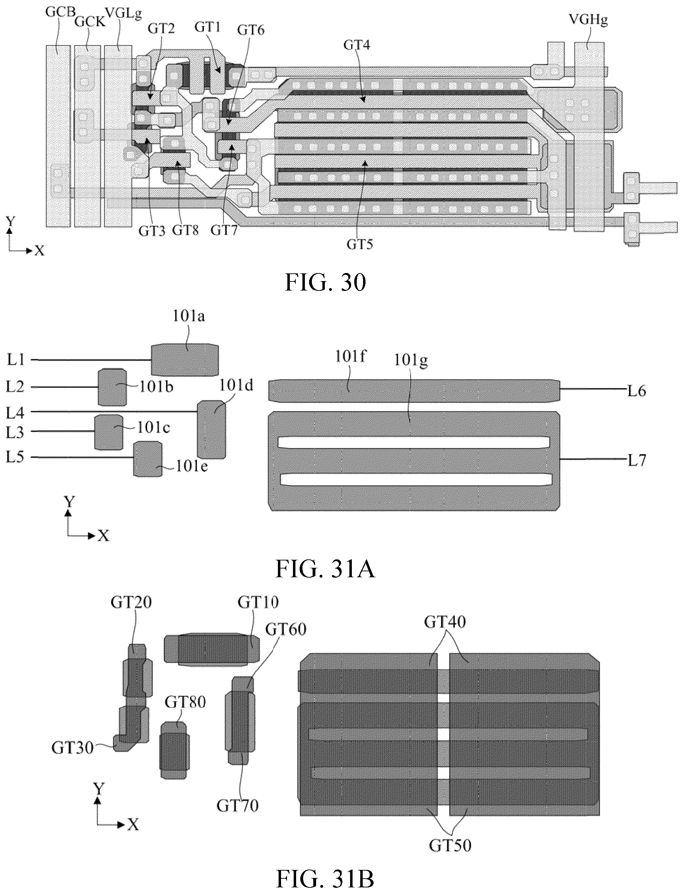

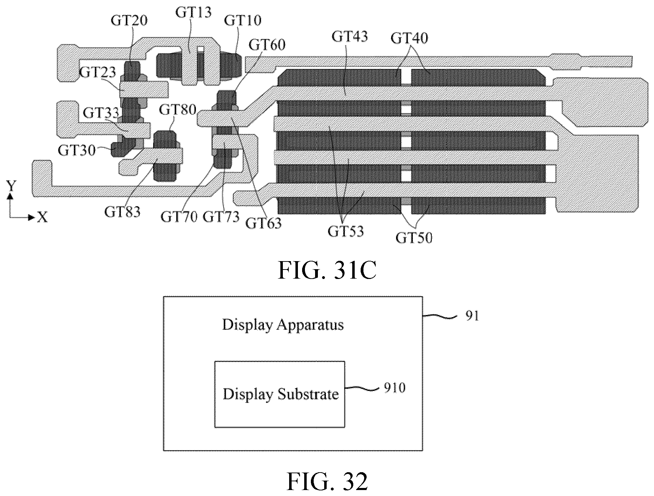

FIG. 30 is a schematic partial plan view of a peripheral region according to at least one embodiment of the present disclosure. FIG. 31A is a schematic partial plan view of a peripheral region after a bottom metal layer is formed in FIG. 30. FIG. 31B is a schematic partial plan view of a peripheral region after a semiconductor layer is formed in FIG. 30. FIG. 31C is a schematic partial plan view of a peripheral region after a first conductive layer is formed in FIG. 30. This example is illustrated by taking a bottom metal layer corresponding to a scan drive sub-circuit as an example, wherein one first circuit unit may include one transistor or one capacitor of the scan drive sub-circuit. Connection lines of the first metal blocks of the bottom metal layer are illustrated in FIG. 31A while the connection lines of the first metal blocks are omitted in FIG. 30, FIG. 31B, and FIG. 31C.

In some examples, as shown in FIGS. 30 to 31C, the bottom metal layer 10 of the peripheral region may include a plurality of first metal blocks (e.g. including first metal blocks 101a to 101g). For example, one first metal block may correspond to one first circuit unit (e.g. a transistor). In some examples, a first metal block 101a may correspond to a first shift transistor, for example, may cover a channel region of an active layer GT10 of the first shift transistor. A first metal block 101b may correspond to a second shift transistor, for example, may cover a channel region of an active layer GT20 of the second shift transistor. A first metal block 101c may correspond to a third shift transistor, for example, may cover a channel region of an active layer GT30 of the third shift transistor. A first metal block 101d may correspond to a sixth shift transistor and a seventh shift transistor, for example, may cover channel regions of an active layer GT60 of the sixth shift transistor and an active layer GT70 of the seventh shift transistor. A first metal block 101e may correspond to an eighth shift transistor, for example, may cover a channel region of an active layer GT80 of the eighth shift transistor. A first metal block 101f may correspond to a fourth shift transistor, for example, may cover a channel region of an active layer GT40 of the fourth shift transistor. A first metal block 101g may correspond to a fifth shift transistor, for example, may cover a channel region of an active layer GT50 of the fifth shift transistor. In some other examples, at least two first metal blocks in FIG. 30A may be connected to each other and formed into an integral structure.

In some examples, as shown in FIG. 31A, the plurality of first metal blocks 101a to 101g may be independently disposed. The first metal block 101a may be electrically connected with a first signal line L1 through a first connection line, a first metal block 101b may be electrically connected with a second signal line L2 through a second connection line, a first metal block 101c may be electrically connected with a third signal line L3 through a third connection line, a first metal block 101d may be electrically connected with a fourth signal line L4 through a fourth connection line, a first metal block 101e may be electrically connected with a fifth signal line L5 through a fifth connection line, a first metal block 101f may be electrically connected with a sixth signal line L6 through a sixth connection line, and a first metal block 101g may be electrically connected with a seventh signal line L7 through a seventh connection line. The first signal line L1 to the seventh signal lines L7 may be different kinds of signal lines, i.e., for transmitting different signals; alternatively, at least two of the first to seventh signal lines L1 to L7 may transmit the same kind of signals, for example, the first to seventh signal lines L1 to L7 may all be the same kind of signal lines, i.e. for transmitting the same signal. In some examples, the first to seventh signal lines L1 to L7 may each be configured to transmit the same signal as that of the first pixel power supply traces. In some other examples, the first to fifth signal lines L1 to L5 may each be configured to transmit the same signal as that of the peripheral power supply trace, and the sixth and seventh signal lines L6 and L7 may each be configured to transmit the same signal as that of the first pixel power supply trace. However, the embodiment is not limited thereto. Rest of the structure of the display substrate according to this embodiment may be referred to descriptions of the aforementioned embodiments, and will not be repeated here.

In some other examples, the gate drive circuit of the peripheral region may also include a reset control drive circuit that may be configured to provide a reset control signal to a reset control line of the display region. For example, the reset control drive circuit may be located between the scan drive circuit and the light emitting control drive circuit. The bottom metal layer may include a metal block corresponding to the reset control drive circuit to realize the electrostatic shielding to the reset control drive circuit. Signal lines connected to the metal blocks sheltering the reset control drive circuit and signal lines connected to the first metal blocks may be a same kind of signal lines, or the signal lines connected to the metal blocks sheltering the reset control drive circuit and signal lines connected to the second metal blocks may be a same kind of signal lines, or the signal lines connected to the metal blocks sheltering the reset control drive circuit and signal lines connected to the first metal blocks and the second metal blocks may be different kinds of signal lines. However, a structure of a gate drive circuit is not limited in the present embodiment.

In some other examples, the above embodiments may be combined with each other. In some examples, the bottom metal layer may be a planar metal layer, wherein the first metal blocks and the second metal blocks may for example both be planar metal blocks, and may be formed into an integral structure without a hollow portion or a hollow region disposed. In some other examples, at least one of the first metal block and the second metal block of the bottom metal layer may be provided with a hollow portion or a hollow region. In some other examples, the bottom metal layer may be electrically connected with the clock signal line (e.g. at least one of a first clock signal line to a fourth clock signal line) through the first metal block or the second metal block to receive a pulse signal.

FIG. 32 is a schematic diagram of a display apparatus according to at least one embodiment of the present disclosure. In some examples, as shown in FIG. 32, the present embodiment provides a display apparatus 91, including a display substrate 910. The display substrate 910 may be an OLED display substrate, a QLED display substrate, a micro-LED display substrate, or a mini-LED display substrate. The display apparatus 91 may be any product or component with a display function, such as an OLED display apparatus, a watch, a mobile phone, a tablet computer, a television, a display, a laptop computer, a digital photo frame, and a navigator. However, the embodiment is not limited thereto.

The drawings of the present disclosure only involve structures involved in the present disclosure, and other structures may refer to conventional designs. The embodiments of the present disclosure, i.e., features in the embodiments, may be combined with each other to obtain new embodiments if there is no conflict. Those of ordinary skills in the art should understand that modifications or equivalent replacements may be made to the technical solutions of the present disclosure without departing from the scope of the technical solutions of the present disclosure, which shall all fall within the scope of the claims of the present application.

## Claims

1. A display substrate, comprising:
a base substrate, comprising a display region (AA) and a peripheral region (BB) located at a periphery of the display region (AA);
a bottom metal layer (10), at least located in the peripheral region (BB) and electrically connected with at least one kind of signal lines;
a gate drive circuit, located in the peripheral region (BB) and on a side of the bottom metal layer (10) away from the base substrate; wherein the gate drive circuit comprises a plurality of first circuit units;
wherein an orthographic projection of the bottom metal layer (10) on the base substrate is at least partially overlapped with an orthographic projection of at least one first circuit unit on the base substrate,
wherein the bottom metal layer (10) comprises: a plurality of first metal blocks (101), an orthographic projection of at least one first metal block (101) on the base substrate is at least partially overlapped with an orthographic projection of one or more first circuit units on the base substrate;
the plurality of first metal blocks (101) are of an integral structure, and are electrically connected with a same kind of signal lines,
**characterised in that**
the at least one first metal block (101) has a first hollow portion, and the at least one first circuit unit comprises an output transistor; an orthographic projection of the first hollow portion of the at least one first metal block on the base substrate is partially overlapped with an orthographic projection of a doped region of an active layer of the output transistor on the base substrate.

2. The display substrate according to claim 1, wherein the at least one first circuit unit comprises at least one transistor; the orthographic projection of the bottom metal layer (10) on the base substrate is at least partially overlapped with an orthographic projection of an active layer of at least one transistor of the at least one first circuit unit on the base substrate.

3. The display substrate according to claim 2, wherein the active layer of the at least one transistor comprises at least one channel region; the orthographic projection of the bottom metal layer (10) on the base substrate covers an orthographic projection of the channel region of the active layer of the at least one transistor on the base substrate.

4. The display substrate according to claim 2, wherein the at least one first circuit unit comprises a plurality of transistors; the orthographic projection of the bottom metal layer (10) on the base substrate covers orthographic projections of active layers of a plurality of transistors of the at least one first circuit unit on the base substrate.

5. The display substrate according to any one of claims 1 to 4, wherein the at least one first circuit unit comprises: an input sub-circuit (51) and a first control sub-circuit (52); the input sub-circuit (51) is configured to provide a signal of a shift input terminal (GIN) to a first shift node (GN1) under control of a first clock signal line (GCK); the first control sub-circuit (52) is configured to control a potential of a second shift node (GN2) under control of the first clock signal line (GCK) and the first shift node (GN1); the first control sub-circuit (52) is electrically connected with the second shift node (GN2) through a node adapter electrode; the orthographic projection of the bottom metal layer (10) on the base substrate is at least partially overlapped with an orthographic projection of the node adapter electrode on the base substrate;
or
the at least one first circuit unit comprises: an input sub-circuit (51), a first control sub-circuit (52), and a second control sub-circuit (54); the input sub-circuit (51) is configured to provide a signal of a shift input terminal (GIN) to a first shift node (GN1) under control of a first clock signal line (GCK); the first control sub-circuit (52) is configured to control a potential of a second shift node (GN2) under control of the first clock signal line (GCK) and the first shift node (GN1); the second control sub-circuit (54) is configured to turn on the first shift node (GN1) and a third shift node (GN3) under control of a second power supply line (VGLg); the input sub-circuit (51), the first control sub-circuit (52) and the second control sub-circuit (54) are electrically connected with the first shift node (GN1) through a first connection electrode; the orthographic projection of the bottom metal layer (10) on the base substrate is at least partially overlapped with an orthographic projection of the first connection electrode on the base substrate;
or
the at least one first circuit unit comprises: a second control sub-circuit (54) and an output sub-circuit (53); the second control sub-circuit (54) is configured to turn on a first shift node (GN1) and a third shift node (GN3) under control of a second power supply line (VGLg); the output sub-circuit (53) is configured to control an output signal of a shift output terminal (GOUT) under control of a second shift node (GN2) and the third shift node (GN3); the second control sub-circuit (54) and the output sub-circuit (53) are electrically connected with the third shift node (GN3) through a seventh connection electrode; the orthographic projection of the bottom metal layer (10) on the base substrate covers an orthographic projection of the seventh connection electrode on the base substrate.

6. The display substrate according to claim 1, wherein the at least one first circuit unit comprises at least one capacitor; the orthographic projection of the bottom metal layer (10) on the base substrate is at least partially overlapped with an orthographic projection of the at least one capacitor of the at least one first circuit unit on the base substrate.

7. The display substrate according to claim 1, wherein the integral structure formed by the plurality of first metal blocks (101) is a planar metal block.

8. The display substrate according to claim 1, wherein the gate drive circuit further comprises: a plurality of cascaded second circuit units located on one side of the plurality of first circuit units away from the display region; at least one second circuit unit is electrically connected with a first output connection line extending toward one side of the display region

9. The display substrate according to claim 1, wherein the gate drive circuit further comprises: a plurality of cascaded second circuit units located on one side of the plurality of first circuit units away from the display region (AA); the bottom metal layer (10) further comprises a plurality of second metal blocks (105) located on one side of the plurality of first metal blocks (101) away from the display region; an orthographic projection of at least one of the plurality of second metal blocks (105) on the base substrate is at least partially overlapped with an orthographic projection of one or more second circuit units on the base substrate;
the plurality of second metal blocks (105) are of an integral structure, and the plurality of second metal blocks (105) and the plurality of first metal blocks (101) are electrically connected with different signal lines for transmitting different signals respectively.

10. The display substrate according to claim 1, wherein the gate drive circuit comprises: a plurality of cascaded first circuit units and a plurality of cascaded second circuit units; the plurality of cascaded second circuit units are located on one side of the plurality of cascaded first circuit units away from the display region; the bottom metal layer further comprises a plurality of second metal blocks, wherein the plurality of second metal blocks are located on one side of the plurality of first metal blocks away from the display region; and an orthographic projection of at least one of the plurality of second metal blocks on the base substrate is at least partially overlapped with an orthographic projection of one or more second circuit units on the base substrate;
at least one second metal block and at least one first metal block are connected with a same kind of signal lines.

11. A display apparatus, comprising the display substrate according to any one of claims 1 to 10.

## Patentansprüche

1. Anzeigesubstrat, umfassend:
ein Basissubstrat, das einen Anzeigebereich (AA) und einen an einem Rand des Anzeigebereichs (AA) angeordneten Randbereich (BB) umfasst;
eine untere Metallschicht (10), die zumindest im Randbereich (BB) angeordnet und mit mindestens einer Art von Signalleitungen elektrisch verbunden ist;
eine Gate-Ansteuerschaltung, die im Randbereich (BB) und auf einer dem Basissubstrat abgewandten Seite der unteren Metallschicht (10) angeordnet ist, wobei die Gate-Ansteuerschaltung eine Vielzahl von ersten Schaltungseinheiten umfasst;
wobei sich eine orthogonale Projektion der unteren Metallschicht (10) auf das Basissubstrat zumindest teilweise mit einer orthogonalen Projektion mindestens einer ersten Schaltungseinheit auf das Basissubstrat überlappt,
wobei die untere Metallschicht (10) eine Vielzahl von ersten Metallblöcken (101) umfasst, wobei sich eine orthogonale Projektion mindestens eines ersten Metallblocks (101) auf das Basissubstrat zumindest teilweise mit einer orthogonalen Projektion einer oder mehrerer erster Schaltungseinheiten auf das Basissubstrat überlappt,
wobei die Vielzahl von ersten Metallblöcke (101) eine einstückige Struktur bilden und mit Signalleitungen derselben Art elektrisch verbunden sind,
**dadurch gekennzeichnet, dass**
der mindestens eine erste Metallblock (101) einen ersten Aussparungsabschnitt aufweist und die mindestens eine erste Schaltungseinheit einen Ausgangstransistor umfasst, wobei sich eine orthogonale Projektion des ersten Aussparungsabschnittes des mindestens einen ersten Metallblocks auf das Basissubstrat teilweise mit einer orthogonalen Projektion eines dotierten Bereichs einer aktiven Schicht des Ausgangstransistors auf das Basissubstrat überlappt.

2. Anzeigesubstrat nach Anspruch 1, wobei die mindestens eine erste Schaltungseinheit mindestens einen Transistor umfasst und sich die orthogonale Projektion der unteren Metallschicht (10) auf das Basissubstrat zumindest teilweise mit einer orthogonalen Projektion einer aktiven Schicht mindestens eines Transistors der mindestens eine erste Schaltungseinheit auf das Basissubstrat überlappt.

3. Anzeigesubstrat nach Anspruch 2, wobei die aktive Schicht des mindestens einen Transistors mindestens einen Kanalbereich umfasst und die orthogonale Projektion der unteren Metallschicht (10) auf das Basissubstrat die orthogonale Projektion des Kanalbereichs der aktiven Schicht des mindestens einen Transistors auf das Basissubstrat überdeckt.

4. Anzeigesubstrat nach Anspruch 2, wobei die mindestens eine erste Schaltungseinheit eine Vielzahl von Transistoren umfasst und die orthogonale Projektion der unteren Metallschicht (10) auf das Basissubstrat die orthogonalen Projektionen der aktiven Schichten einer Vielzahl von Transistoren der mindestens einen ersten Schaltungseinheit auf das Basissubstrat überdeckt.

5. Anzeigesubstrat nach einem der Ansprüche 1 bis 4, wobei die mindestens eine erste Schaltungseinheit eine Eingangs-Teilschaltung (51) und eine erste Steuer-Teilschaltung (52) umfasst; die Eingangs-Teilschaltung (51) dazu ausgebildet ist, unter der Steuerung einer ersten Taktsignalleitung (GCK) ein Signal eines Schiebe-Eingangsanschlusses (GIN) an einen ersten Schiebeknoten (GN1) zu liefern; die erste Steuer-Teilschaltung (52) dazu ausgebildet ist, ein Potential eines zweiten Schiebeknotens (GN2) unter der Steuerung der ersten Taktsignalleitung (GCK) und des ersten Schiebeknotens (GN1) zu steuern; die erste Steuer-Teilschaltung (52) über eine Knotenadapterelektrode mit dem zweiten Schiebeknoten (GN2) elektrisch verbunden ist; und die orthogonale Projektion der unteren Metallschicht (10) auf das Basissubstrat sich mindestens teilweise mit einer orthogonalen Projektion der Knotenadapterelektrode auf das Basissubstrat überlappt;
oder
die mindestens eine erste Schaltungseinheit eine Eingangs-Teilschaltung (51), eine erste Steuer-Teilschaltung (52) und eine zweite Steuer-Teilschaltung (54) umfasst; die Eingangs-Teilschaltung (51) dazu ausgebildet ist, unter der Steuerung einer ersten Taktsignalleitung (GCK) ein Signal eines Schiebe-Eingangsanschlusses (GIN) an einen ersten Schiebeknoten (GN1) zu liefern; die erste Steuer-Teilschaltung (52) dazu ausgebildet ist, ein Potential eines zweiten Schiebeknotens (GN2) unter der Steuerung der ersten Taktsignalleitung (GCK) und des ersten Schiebeknotens (GN1) zu steuern; die zweite Steuer-Teilschaltung (54) dazu ausgebildet ist, den ersten Schiebeknoten (GN1) und einen dritten Schiebeknoten (GN3) unter der Steuerung einer zweiten Spannungsversorgungsleitung (VGLg) einzuschalten; die Eingangs-Teilschaltung (51), die erste Steuer-Teilschaltung (52) und die zweite Steuer-Teilschaltung (54) über eine erste Verbindungselektrode mit dem ersten Schiebeknoten (GN1) elektrisch verbunden sind: und die orthogonale Projektion der unteren Metallschicht (10) auf das Basissubstrat sich mindestens teilweise mit einer orthogonalen Projektion der ersten Verbindungselektrode auf das Basissubstrat überlappt;
oder
die mindestens eine erste Schaltungseinheit eine zweite Steuer-Teilschaltung (54) und eine Ausgangs-Teilschaltung (53) umfasst; die zweite Steuer-Teilschaltung (54) dazu ausgebildet ist, einen ersten Schiebeknoten (GN1) und einen dritten Schiebeknoten (GN3) unter der Steuerung einer zweiten Spannungsversorgungsleitung (VGLg) einzuschalten; die Ausgangs-Teilschaltung (53) dazu ausgebildet ist, ein Ausgangssignal eines Schiebe-Ausgangsanschlusses (GOUT) unter der Steuerung eines zweiten Schiebeknotens (GN2) und des dritten Schiebeknotens (GN3) zu steuern; die zweite Steuer-Teilschaltung (54) und die Ausgangs-Teilschaltung (53) über eine siebte Verbindungselektrode mit dem dritten Schiebeknoten (GN3) elektrisch verbunden sind; und die orthogonale Projektion der unteren Metallschicht (10) auf das Basissubstrat die orthogonale Projektion der siebten Verbindungselektrode auf das Basissubstrat überdeckt.

6. Anzeigesubstrat nach Anspruch 1, wobei die mindestens eine erste Schaltungseinheit mindestens einen Kondensator umfasst und die orthogonale Projektion der unteren Metallschicht (10) auf das Basissubstrat sich mindestens teilweise mit der orthogonalen Projektion des mindestens einen Kondensators der mindestens einen ersten Schaltungseinheit auf das Basissubstrat überlappt.

7. Anzeigesubstrat nach Anspruch 1, wobei die durch die Vielzahl erster Metallblöcke (101) gebildete einstückige Struktur ein flächiger Metallblock ist.

8. Anzeigesubstrat nach Anspruch 1, wobei die Gate-Ansteuerschaltung ferner eine Vielzahl von hintereinander geschalteten zweiten Schaltungseinheiten, die auf einer vom Anzeigebereich entfernten Seite der Vielzahl von ersten Schaltungseinheiten angeordnet sind, umfasst und mindestens eine zweite Schaltungseinheit mit einer ersten Ausgangsverbindungsleitung elektrisch verbunden ist, die sich in Richtung einer Seite des Anzeigebereichs erstreckt.

9. Anzeigesubstrat nach Anspruch 1, wobei die Gate-Ansteuerschaltung ferner eine Vielzahl von hintereinander geschalteten zweiten Schaltungseinheiten umfasst, die auf einer vom Anzeigebereich (AA) entfernten Seite der Vielzahl von ersten Schaltungseinheiten angeordnet sind; die untere Metallschicht (10) ferner eine Vielzahl von zweiten Metallblöcken (105) umfasst, die auf einer vom Anzeigebereich entfernten Seite der Vielzahl von ersten Metallblöcken (101) angeordnet sind; und eine orthogonale Projektion mindestens eines der Vielzahl von zweiten Metallblöcke (105) auf das Basissubstrat sich mindestens teilweise mit einer orthogonalen Projektion einer oder mehrerer zweiter Schaltungseinheiten auf das Basissubstrat überlappt; wobei die Vielzahl von zweiten Metallblöcken (105) eine einstückige Struktur bilden, und die Vielzahl von zweiten Metallblöcken (105) sowie die Vielzahl von ersten Metallblöcken (101) jeweils mit unterschiedlichen Signalleitungen zum Übertragen unterschiedlicher Signale elektrisch verbunden sind.

10. Anzeigesubstrat nach Anspruch 1, wobei die Gate-Ansteuerschaltung eine Vielzahl von hintereinander geschalteten ersten Schaltungseinheiten und eine Vielzahl von hintereinander geschalteten zweiten Schaltungseinheiten umfasst; die Vielzahl von hintereinander geschalteten zweiten Schaltungseinheiten auf einer vom Anzeigebereich entfernten Seite der Vielzahl von ersten Schaltungseinheiten angeordnet sind; die untere Metallschicht ferner eine Vielzahl von zweiten Metallblöcken umfasst, wobei die Vielzahl von zweiten Metallblöcken auf einer vom Anzeigebereich entfernten Seite der Vielzahl von ersten Metallblöcken angeordnet sind; und eine orthogonale Projektion mindestens eines der mehreren zweiten Metallblöcke auf das Basissubstrat sich mindestens teilweise mit einer orthogonalen Projektion einer oder mehrerer zweiter Schaltungseinheiten auf das Basissubstrat überlappt;
wobei mindestens ein zweiter Metallblock und mindestens ein erster Metallblock mit Signalleitungen derselben Art verbunden sind.

11. Anzeigevorrichtung, die das Anzeigesubstrat nach einem der Ansprüche 1 bis 10 umfasst.

## Revendications

1. Substrat d'affichage, comprenant :
un substrat de base, comprenant une région d'affichage (AA) et une région périphérique (BB) située à une périphérie de la région d'affichage (AA) ;
une couche métallique inférieure (10), située au moins dans la région périphérique (BB) et connectée électriquement, au moins, à un type de lignes de signal ;
un circuit de commande de grille, situé dans la région périphérique (BB) et sur un côté de la couche métallique inférieure (10) éloignés du substrat de base ; dans lequel le circuit de commande de grille comprend une pluralité de premières unités de circuit ;
dans lequel une projection orthographique de la couche métallique inférieure (10) sur le substrat de base chevauche au moins partiellement une projection orthographique d'au moins une première unité de circuit sur le substrat de base,
dans lequel la couche métallique inférieure (10) comprend : une pluralité de premiers blocs métalliques (101), une projection orthographique d'au moins un premier bloc métallique (101) sur le substrat de base chevauchant au moins partiellement une projection orthographique d'une ou de plusieurs premières unités de circuit sur le substrat de base ;
la pluralité de premiers blocs métalliques (101) ont une structure d'un seul tenant et sont connectés électriquement à un même type de lignes de signal ;
**caractérisé en ce que**
l'au moins un premier bloc métallique (101) a une première partie creuse, et l'au moins une première unité de circuit comprend un transistor de sortie ; une projection orthographique de la première partie creuse de l'au moins un premier bloc métallique sur le substrat de base chevauche partiellement une projection orthographique d'une région dopée d'une couche active du transistor de sortie sur le substrat de base.

2. Substrat d'affichage, selon la revendication 1, dans lequel l'au moins une première unité de circuit comprend au moins un transistor ; la projection orthographique de la couche métallique inférieure (10) sur le substrat de base chevauche au moins partiellement une projection orthographique d'une couche active d'au moins un transistor de l'au moins une première unité de circuit sur le substrat de base.

3. Substrat d'affichage, selon la revendication 2, dans lequel la couche active de l'au moins un transistor comprend au moins une région de canal ; la projection orthographique de la couche métallique inférieure (10) sur le substrat de base recouvre une projection orthographique de la région de canal de la couche active de l'au moins un transistor sur le substrat de base.

4. Substrat d'affichage, selon la revendication 2, dans lequel l'au moins une première unité de circuit comprend une pluralité de transistors ; la projection orthographique de la couche métallique inférieure (10) sur le substrat de base recouvre des projections orthographiques de couches actives d'une pluralité de transistors de l'au moins une première unité de circuit sur le substrat de base.

5. Substrat d'affichage, selon l'une quelconque des revendications 1 à 4, dans lequel l'au moins une première unité de circuit comprend : un sous-circuit d'entrée (51) et un premier sous-circuit de commande (52) ; le sous-circuit d'entrée (51) est configuré pour fournir un signal d'une borne d'entrée de décalage (GIN) à un premier nœud de décalage (GN1) sous la commande d'une première ligne de signal d'horloge (GCK) ; le premier sous-circuit de commande (52) est configuré pour commander un potentiel d'un deuxième nœud de décalage (GN2) sous la commande de la première ligne de signal d'horloge (GCK) et du premier nœud de décalage (GN1) ; le premier sous-circuit de commande (52) est connecté électriquement au deuxième nœud de décalage (GN2) par l'intermédiaire d'une électrode d'adaptateur de nœud ; la projection orthographique de la couche métallique inférieure (10) sur le substrat de base chevauche au moins partiellement une projection orthographique de l'électrode d'adaptateur de nœud sur le substrat de base ;
ou
l'au moins une première unité de circuit comprend : un sous-circuit d'entrée (51), un premier sous-circuit de commande (52) et un deuxième sous-circuit de commande (54) ; le sous-circuit d'entrée (51) est configuré pour fournir un signal d'une borne d'entrée de décalage (GIN) à un premier nœud de décalage (GN1) sous la commande d'une première ligne de signal d'horloge (GCK) ; le premier sous-circuit de commande (52) est configuré pour commander un potentiel d'un deuxième nœud de décalage (GN2) sous la commande de la première ligne de signal d'horloge (GCK) et du premier nœud de décalage (GN1) ; le deuxième sous-circuit de commande (54) est configuré pour activer le premier nœud de décalage (GN1) et un troisième nœud de décalage (GN3) sous la commande d'une deuxième ligne d'alimentation (VGLg) ; le sous-circuit d'entrée (51), le premier sous-circuit de commande (52) et le deuxième sous-circuit de commande (54) sont connectés électriquement au premier nœud de décalage (GN1) par l'intermédiaire d'une première électrode de connexion ; la projection orthographique de la couche métallique inférieure (10) sur le substrat de base chevauche au moins partiellement une projection orthographique de la première électrode de connexion sur le substrat de base ;
ou
l'au moins une première unité de circuit comprend : un deuxième sous-circuit de commande (54) et un sous-circuit de sortie (53) ; le deuxième sous-circuit de commande (54) est configuré pour activer un premier nœud de décalage (GN1) et un troisième nœud de décalage (GN3) sous la commande d'une deuxième ligne d'alimentation (VGLg) ; le sous-circuit de sortie (53) est configuré pour commander un signal de sortie d'une borne de sortie de décalage (GOUT) sous la commande d'un deuxième nœud de décalage (GN2) et du troisième nœud de décalage (GN3) ; le deuxième sous-circuit de commande (54) et le sous-circuit de sortie (53) sont connectés électriquement au troisième nœud de décalage (GN3) par l'intermédiaire d'une septième électrode de connexion ; la projection orthographique de la couche métallique inférieure (10) sur le substrat de base recouvre une projection orthographique de la septième électrode de connexion sur le substrat de base.

6. Substrat d'affichage, selon la revendication 1, dans lequel l'au moins une première unité de circuit comprend au moins un condensateur ; la projection orthographique de la couche métallique inférieure (10) sur le substrat de base chevauche au moins partiellement une projection orthographique de l'au moins un condensateur de l'au moins une première unité de circuit sur le substrat de base.

7. Substrat d'affichage, selon la revendication 1, dans lequel la structure d'un seul tenant formée par la pluralité de premiers blocs métalliques (101) est un bloc métallique plat.

8. Substrat d'affichage, selon la revendication 1, dans lequel le circuit de commande de grille comprend en outre : une pluralité de deuxièmes unités de circuit en cascade situées sur un côté de la pluralité de premières unités de circuit éloigné de la région d'affichage ; au moins une deuxième unité de circuit est connectée électriquement à une première ligne de connexion de sortie s'étendant vers un côté de la région d'affichage.

9. Substrat d'affichage, selon la revendication 1, dans lequel le circuit de commande de grille comprend en outre : une pluralité de deuxièmes unités de circuit en cascade situées sur un côté de la pluralité de premières unités de circuit éloigné de la région d'affichage (AA) ; la couche métallique inférieure (10) comprend en outre une pluralité de deuxièmes blocs métalliques (105) situés sur un côté de la pluralité de premiers blocs métalliques (101) éloigné de la région d'affichage ; une projection orthographique d'au moins un de la pluralité de deuxièmes blocs métalliques (105) sur le substrat de base chevauche au moins partiellement une projection orthographique d'une ou de plusieurs deuxièmes unités de circuit sur le substrat de base ;
la pluralité de deuxièmes blocs métalliques (105) ont une structure d'un seul tenant, et la pluralité de deuxièmes blocs métalliques (105) et la pluralité de premiers blocs métalliques (101) sont connectés électriquement à des lignes de signal différentes pour transmettre des signaux différents respectivement.

10. Substrat d'affichage, selon la revendication 1, dans lequel le circuit de commande de grille comprend : une pluralité de premières unités de circuit en cascade et une pluralité de deuxièmes unités de circuit en cascade ; la pluralité de deuxièmes unités de circuit en cascade sont situées sur un côté de la pluralité de premières unités de circuit en cascade éloigné de la région d'affichage ; la couche métallique inférieure comprend en outre une pluralité de deuxièmes blocs métalliques, dans lequel la pluralité de deuxièmes blocs métalliques sont situés sur un côté de la pluralité de premiers blocs métalliques éloigné de la région d'affichage ; et une projection orthographique d'au moins un de la pluralité de deuxièmes blocs métalliques sur le substrat de base chevauche au moins partiellement une projection orthographique d'une ou de plusieurs deuxièmes unités de circuit sur le substrat de base ;
au moins un deuxième bloc métallique et au moins un premier bloc métallique sont connectés à un même type de lignes de signal.

11. Appareil d'affichage, comprenant le substrat d'affichage selon l'une quelconque des revendications 1 à 10.
